Europäisches Patentamt

European Patent Office

Office européen des brevets

(19)

(11) **EP 0 797 182 A1**

(12) **EUROPEAN PATENT APPLICATION**

(43) Date of publication:
24.09.1997 Bulletin 1997/39

(51) Int. Cl.⁶: **G09G 3/36**

(21) Application number: 97104580.2

(22) Date of filing: 18.03.1997

(84) Designated Contracting States:
**DE FR GB**

(30) Priority: 19.03.1996 JP 62996/96
04.04.1996 JP 82340/96
11.06.1996 JP 148986/96
18.06.1996 JP 156790/96

(71) Applicant: **HITACHI, LTD.**
**Chiyoda-ku, Tokyo 101 (JP)**

(72) Inventors:
• **Mikami, Yoshiro**
**Hitachi-shi, Ibaraki 319-12 (JP)**
• **Minemura, Tetsuro**
**Hitachioota-shi, Ibaraki 313 (JP)**
• **Tsumura, Makoto**
**Hitachi-shi, Ibaraki 316 (JP)**

• **Kuwabara, Kazuhiro**
**Hitachi-shi, Ibaraki 316 (JP)**
• **Komura, Shinichi**
**Hitachi-shi, Ibaraki 319-12 (JP)**
• **Ohkubo, Tatsuya**
**Hitachinaka-shi, Ibaraki 312 (JP)**
• **Sato, Hideo**
**Hitachi-shi, Ibaraki 316 (JP)**
• **Hirota, Shoichi**
**Hitachi-shi, Ibaraki 319-12 (JP)**
• **Adachi, Masaya**
**6-chome, Hitachi-shi, Ibaraki 316 (JP)**
• **Masuda, Kazuhito**
**Hitachi-shi, Ibaraki 319-12 (JP)**

(74) Representative: **Beetz & Partner**
**Patentanwälte**
**Steinsdorfstrasse 10**
**80538 München (DE)**

(54) **Active matrix LCD with data holding circuit in each pixel**

(57) An improved liquid crystal display apparatus for low power consumption is disclosed. The display apparatus is provided with the following within each of the regions surrounded by a plurality of scanning electrodes (3) and a plurality of signal electrodes (4): a display data holding circuit (5) connected to the corresponding scanning electrodes (3) and signal electrodes (4), for fetching and storing a display data from the signal electrode (4) in response to a scanning signal; a switching device connected to the display data holding circuit (5), its switching operation being controlled by the holding circuit (5); a display electrode (7) connected to the switching device.

FIG.1

EP 0 797 182 A1

**Description**

BACKGROUND OF THE INVENTION

The present invention relates to a liquid crystal display apparatus, particularly to a TFT active matrix type liquid crystal display apparatus for low power consumption.

A conventional driving system of a TFT active matrix type liquid crystal display apparatus will be explained hereinafter. A known active matrix type panel technique is described in detail in Shunsuke Kobayashi "A Color Liquid Crystal Display" Sangyo Tosho Co. Ltd.

The TFT active matrix type liquid crystal display apparatus is driven by using a line-at-a-time scanning method, in which one scanning pulse is applied every one frame period of time. One frame period is generally set to about 1/60 second. These pulses applied from the top panel to the bottom panel each has a certain delay of time in order from top to bottom.

Because one pixel is formed of 3 dots in a color panel having 640 x 480 dots, the total number of dots is 1920 x 480. Further, because 480 gate wires are scanned in one frame, the time width of the scanning pulse is about 37 μs.

Liquid crystal driving voltages to be applied to the liquid crystal to which the scanning pulse is applied, are applied to signal electrodes in synchronization with the scanning pulse. In the selected pixel that the gate pulse is applied, the voltage of a gate electrode of the TFT connected to the scanning electrode increases, and thus the TFT turns to a "ON" state. At this time, the liquid crystal driving voltage is applied to a display electrode via a source and a drain of the TFT, and thereby a pixel capacity is charged, comprised of a liquid crystal capacity formed between the display electrode and a opposed electrode formed on an counter substrate and a load capacity provided to a pixel. By repeating this operation, the liquid crystal applying voltage is applied repeatedly to the pixel capacity of the whole surface of the panel every frame time.

Further, because an alternating voltage is required to drive the liquid crystal, the voltage in which its polarity is inverted every frame time is applied to the signal electrode. Therefore, a liquid crystal driving frequency is 30 Hz, a half of the frame frequency of normal 60 Hz. As a result, flicker appears and it becomes difficult to watch the display. In the conventional liquid crystal display apparatus, the effect of the flicker is decreased by inverting alternately the polarity of the liquid crystal driving voltage at every adjacent pixel. Most of the electric power for driving the liquid crystal panel is consumed to charge and discharge repeatedly the capacity at intersecting portions of the scanning wires and the signal wires and the capacity of the liquid crystal between the wires and the opposed electrodes formed on the whole surface of the counter substrate every time the gates are selected.

In the current panel configuration and the liquid crystal driving system, the electric power consumed to charge and discharge repeatedly the capacity at intersecting portions of the scanning wires and the signal wires and the capacity of the liquid crystal between the wires and the opposed electrodes formed on the whole surface of the counter substrate every time of the selection of the gates, occupies a major percentage of the total power consumption. While it is possible to reduce the power consumption by narrowing the width of the wire or lowering the liquid crystal driving frequency, to narrow the width of the wire leads to the increase of a high impedance to occur the delay and the distortion, and to lower the liquid crystal driving frequency links to the drop of the response speed of the display and the occurrence of the flicker.

SUMMARY OF THE INVETNION

An object of the present invention is to provide an improved liquid crystal display apparatus for low power consumption.

Another object of the present invention is to provide an improved and brief liquid crystal display apparatus having not an image memory.

A further object of the present invention is to provide an improved liquid crystal display apparatus which can display with multi-gray levels.

Preferably, the present invention has the following configuration for implementaion.

(1) A liquid crystal display apparatus has a pair of substrates of which at least one substrate is transparent and a liquid crystal layer sandwiched between the substrates. The display apparatus further includes : a plurality of scanning electrodes formed on one of the substrates; and a plurality of signal electrodes intersecting like a matrix with the plurality of scanning electrodes; wherein the display apparatus further includes the followings within each of the regions surrounded by said plurality of scanning electrodes and said plurality of signal electrodes; a display data holding circuit connected to the corresponding scanning electrodes and signal electrodes, for fetching and storing a display data from the signal electrode in response to a scanning signal; a switching device connected to said display data holding circuit, its switching operation being controlled by the holding circuit; and a display electrode connected to said switching device.

(2) A liquid crystal display apparatus having a pair of substrates of which at least one substrate is transparent and a liquid crystal layer sandwiched between the substrates. The display apparatus further includes : a plurality of first scanning electrodes formed on one of the substrates; a plurality of signal electrodes intersecting like a matrix with said plurality of first scanning electrodes; and a plurality of second scanning electrodes provided along said first scanning electrodes or said signal electrodes; wherein the display apparatus further includes the followings within each of the regions surrounded by said plurality of first scanning electrodes and said plurality of signal electrodes; a data holding circuit connected to the corresponding first scanning electrodes, signal electrodes, and second scanning electrodes for fetching and storing a display data from the signal electrodes in response to voltages applied to the first and the second scanning electrodes; a capacitor connected to said data holding circuit; a switching device connected to said capacitor, its switching operation being controlled by a voltage of the capacitor; and a display electrode connected to said switching device.

(3) A liquid crystal display apparatus having a pair of substrates of which at least one substrate is transparent and a liquid crystal layer sandwiched between the substrates. The display apparatus further includes a plurality of scanning electrodes formed on one of the substrates; and a plurality of signal electrodes intersecting like a matrix with each of said plurality of scanning electrodes; wherein the display apparatus further includes the followings within each of the regions forming pixels surrounded by said plurality of scanning electrodes and said plurality of signal electrodes; a sampling data holding circuit connected to the corresponding each of signal electrodes, for sampling and storing signal data from the signal electrode in response to a scanning signal; a gray level selecting circuit connected to said sampling data holding circuit, for selecting the gray levels for the pixel in response to a state of the sampling of said sampling data holding circuit; and a display electrode connected to said gray level selecting circuit.

## BRIEF DESCRIPTION OF THE DRAWINGS

These and other objects, features and advantages of the present invention will be understood more clearly from the following details description with reference to the accompanying drawings, wherein

Fig.1 is a schematic view of the liquid crystal display apparatus according to a first embodiment of the present invention.
Fig.2 is a view showing the configuration of the pixel portion shown in Fig.1.
Fig.3 is a wave form chart of driving signals applied to the pixel portion shown in Fig.2.
Fig.4 is a view showing the configuration of the pixel portion with a memory circuit used in the present invention.
Fig.5 is a view showing the configuration of a mask for the pixel portion with the coplaner structure.
Fig.6 is a view showing of the configuration of another mask for the pixel portion with the coplaner structure.
Fig.7 is a sectional view of the coplaner structure shown in Fig.5.
Fig.8 is a view showing the configuration of the mask for the pixel portion with the inverse stagger structure.
Fig.9 is a sectional view of the inverse stagger structure shown in Fig.8.
Fig.10 is a view showing the configuration of the mask for the pixel portion with the stagger structure.
Fig.11 is a sectional view of the stagger structure shown in Fig.10.
Fig.12 is a view showing the configuration of the pixel portion with a pixel address selecting circuit used in the present invention.
Fig.13 is a wave form chart showing driving signals applied to the pixel portion shown in Fig.12.
Fig.14 is an illustration for the operation of the partial display of the present invention.
Fig.15 is a view showing the configuration of the pixel portion with a gray level selecting TFT used in the present invention.
Fig.16 is a wave form chart of the driving signals applied to the pixel portion shown in Fig.15.
Fig.17 is a view showing the configuration of another pixel portion with a gray level selecting TFT used in the present invention.
Fig.18 is an external view of the pixel portion used in the present invention.
Fig.19 is an external view of the pixel portion used in the conventional liquid crystal display apparatus .
Fig.20 is a view showing the configuration of the mask for the pixel portion with a reflection electrode used in the present invention.

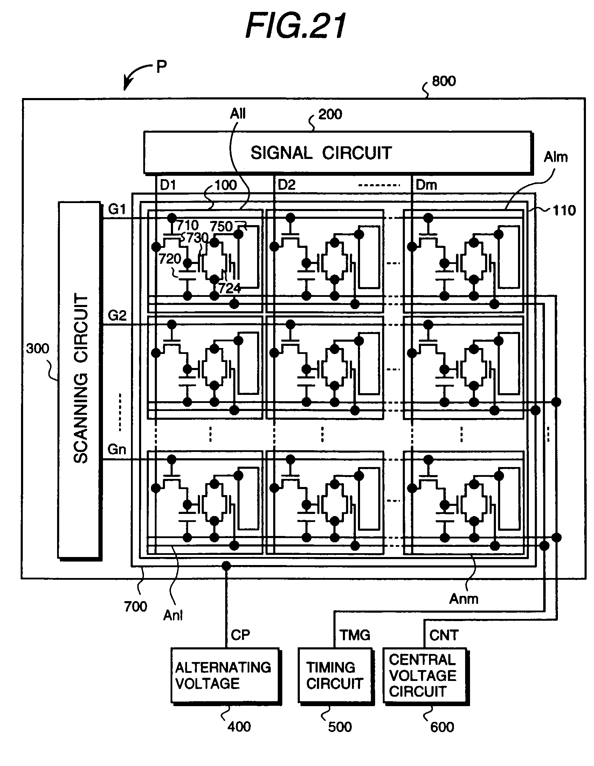

Fig.21 is a view showing the whole configuration of a liquid crystal display apparatus according to a second embodiment of the present invention.
Fig.22 is a circuit diagram of a pixel circuit used in the second embodiment of the present invention.
Fig.23 is a circuit diagram of a timing circuit and an alternating voltage circuit used in the second embodiment of the present invention.
Fig.24 is a timing chart illustrating the operation of the timing circuit and the alternating voltage circuit.
Fig.25 is a timing chart illustrating the operation of the pixel circuit.
Fig.26 is a characteristic diagram showing the relationship between the liquid crystal driving voltage and the liquid crystal transmittance.

Fig.27 is a timing chart illustrating the operation of another example of the pixel circuit.

Fig.28 is a circuit diagram of another example of the timing circuit.

Fig.29 is a timing chart illustrating the operation of the timing circuit and the alternating voltage circuit shown in Fig.28.

Fig.30 is a circuit diagram of another example of the pixel circuit.

Fig.31 is a view showing the whole configuration of a liquid crystal display apparatus according to a third embodiment of the present invention.

Fig.32 is a schematic view showing the configuration of a Y shift register circuit used in the third embodiment of the present invention.

Fig.33 is a schematic view showing the configuration of a motion picture signal circuit.

Fig.34 is a schematic view showing the configuration of a picture data selecting switch circuit.

Fig.35 is a schematic view showing the configuration of a display region.

Fig.36 is a graph showing Vgs - lds characteristics of the TFT.

Fig.37 is a timing chart illustrating the write-in state of a static picture.

Fig.38 is a timing chart illustrating the write-in state of a motion picture.

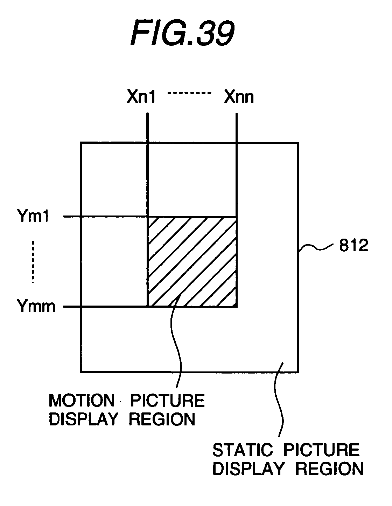

Fig.39 is an illustration of a setting state of the display regions of the static picture and the motion picture.

Fig.40 is a timing chart illustrating the operation of displaying the static picture and the motion picture at the same time.

Fig.41 is a schematic view of the liquid crystal display apparatus according to a fourth embodiment of the present invention.

Fig.42 is a schematic diagram showing the configuration of a driving circuit for flicker preventing electrodes.

Fig.43 is a timing chart of the pulses shown in Fig.42.

Fig.44 is an equivalent circuit diagram of an AND symbol.

Fig.45 is a view showing the configuration of the pixel circuit.

Fig.46 is a wave form chart illustrating the operation of a liquid crystal display device with the pixel circuit shown in Fig.45.

Fig.47 is a view showing the configuration of the pixel circuit with flicker preventing switches.

Fig.48 is a wave form chart illustrating the operation of a liquid crystal display device with the pixel circuit shown in Fig.47.

Fig.49 is a view showing the configuration of the pixel circuit with a p-channel TFT.

Fig.50 is a wave form chart illustrating the operation of a liquid crystal display device with the pixel circuit shown in Fig.49.

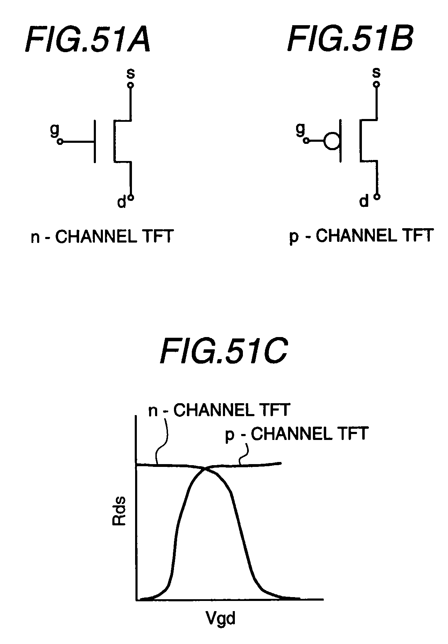

Fig.51 is a graph showing the characteristics of a n-channel TFT and a p-channel TFT.

DESCRIPTION OF THE PREFERRED EMBODIMENTS

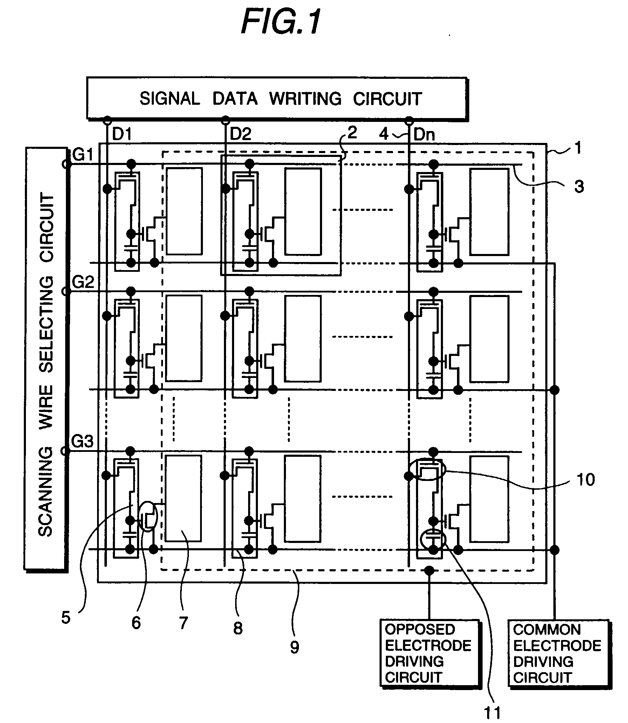

Fig.1 is a schematic view of the liquid crystal display apparatus according to a first embodiment of the present invention. Pixel portions 2 each formed from m high by n wide matrix of dots are arranged in matrix on a display portion 1 formed on a TFT substrate. Each pixel portion comprises a display data holding circuit 5, pixel driving TFT 6 and a transparent electrode 7 for display. The display data holding circuit 5 has a sampling TFT 10 provided in the intersection of a scanning electrode 3 and a signal electrode 4. Each scanning electrode is connected to a scanning line selecting circuit, and each signal electrode a signal data write-in circuit.

Common electrodes 8 driven by a common electrode driving circuit are arranged in parallel with the scanning electrodes in every rows. All of the pixel portions are connected in common to the common electrodes. A opposed electrode 9 formed on an counter substrate faces through a liquid crystal to the transparent electrode provided on the TFT substrate. The opposed electrode 9 is driven by a opposed electrode driving circuit.

The liquid crystal display apparatus has a polarizer and a back light (not shown) in addition to the above configuration.

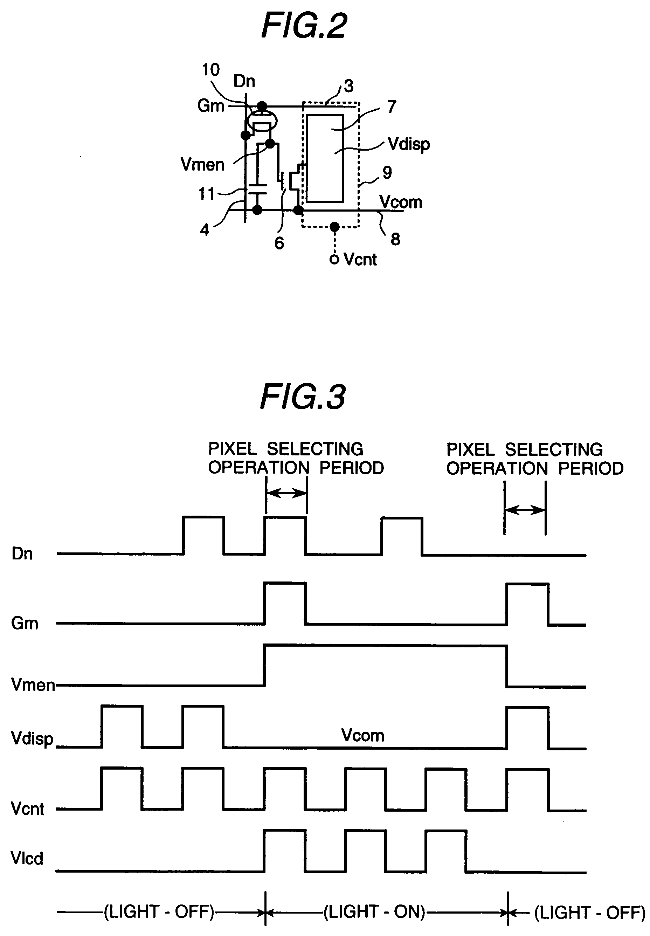

Fig.2 is a view showing the configuration of the pixel portion shown in Fig.1. Fig.3 is a wave form chart of driving signals applied to the pixel portion shown in Fig.2.

The principle of the liquid crystal display apparatus will be explained mainly with reference to Fig.3. When a voltage more than the threshold voltage of the sampling TFT is applied to the scanning wire selected by the scanning wire selecting circuit, a scanning wire Gm is selected. Thereby, a row of pixels connected to the same scanning wire are selected at the same time, and turn to a state in which the pixels are selected. As a result, the sampling TFT turns to an ON state. At this time, a signal data voltage indicative of the display data of a row of pixels is applied to all of the signal wires at the same time.

A signal data voltage on a certain signal wire Dn charges a sampling capacitor 11 through the sampling TFT 10. As a result, a sampling voltage Vmem or a terminal voltage of the capacitor changes. Because one terminal of the capacitor is connected to a gate terminal of the pixel driving TFT 6 which acts as a switch, the sampling voltage controls an ON or Off state of the pixel driving TFT. When the sampling voltage is more than the threshold voltage of the TFT, the TFT turns to the ON state. A current flows between its source and drain, and thus the transparent electrode is electrically connected to the common electrodes. The liquid crystal driving voltage Vcnt applied from the opposed electrode driving circuit to the opposed electrode 9 is applied between the common electrodes. As a result, the liquid crystal turns to a ON state or display state.

While, when the sampling voltage is less than the threshold voltage of the TFT, the TFT turns to an OFF state. A current stops flowing between its source and drain. As a result, the display turns to the OFF state. In this embodiment, the signal voltage from the signal electrode is applied to the display electrode, and to the sampling capacitor as a control voltage of the display state. Further, until the scanning electrode is selected next time after the signal is once written to the sampling capacitor, the sampling voltage gradually drops due to a leakage current of the sampling capacitor. Because the quality of display does not change until the sampling voltage becomes less than the threshold voltage, the time constant of the display data holding becomes enough longer than the frame time. It is, therefore, possible to hold suitably the sampling voltage. As a result, the state of the display of the pixel can be held during sufficient time longer than the frame time.

In the prior art, the liquid crystal is directly driven by using the voltage applied from a signal wire. Therefore, the variation in the voltage of a liquid crystal or a TFT causes a factor of the deterioration of the quality of display. For example, when the leakage current of the data holding TFT is 0.1 pA, the threshold voltage is 1 V, the capacity of the data holding capacitor is 1 pF, and the display data signal voltage is 10 V, the time required to discharge to 1 V or the threshold value of the data holding TFT is 90 sec. This discharge time is 5400 times longer than that in the prior art in which the scan is carried out every one sixty seconds. Further, in the liquid crystal driving voltage, its polarity must be inverted every frames. Therefore, even when the display is in the same state, the liquid crystal driving voltage of which polarity is inverted at every frame times must be applied to all the pixels.

According to the present embodiment, Because the scanning electrode and the signal electrode is driven only when the display is rewritten, and the display can be held by applying the liquid crystal driving voltage only between the common electrodes and the opposed electrode when the display is in the same state, the power consumption of a panel can be reduced. Since the display can be rewritten in a unit of scanning electrode, only the signal electrode in a position where the display is rewritten is driven. Because this voltage is gradually changed due to the leakage of insulation of the pixel driving TFT and the sampling capacity and the leakage of an off-current of the sampling TFT, it is preferable to change the sampling voltage, for example, it can change periodically without generating the flicker in a display.

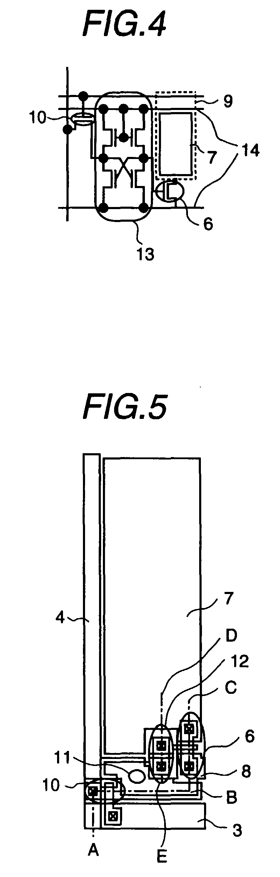

It is possible to obtain an effect similar to the above-mentioned embodiment by using a memory circuit in which a plurality of TFTs is used as the display data holding circuit as shown in Fig.4. According to this example, the output of the sampling TFT 10 is supplied to a gate terminal of the pixel driving TFT 6 through the memory circuit 13 provided instead of the sampling capacity. Because the sampling voltage can be held or stored as a state of the circuit while the power source wiring 14 is necessary to drive the memory circuit, the state written in can be maintained-until the electric power is shut off or new information is written in. Accordingly, the display of a pixel can be maintained for a long time.

It should be appreciated that a flip-flop circuit and a static memory cell circuit using CMOS devices may be used, in addition to the circuit configuration shown in Fig.4.

It is possible to form a two-layer-wiring in the pixel with a display data holding circuit. Therefore, if it may apply a multi-layer wiring technique possible to do the inter-layer connecting and form a capacitor and a TFT, the above-mentioned pixel can apply to any structures such as the existing p-Si coplaner structure, inverse-Stagger structure and Stagger structure.

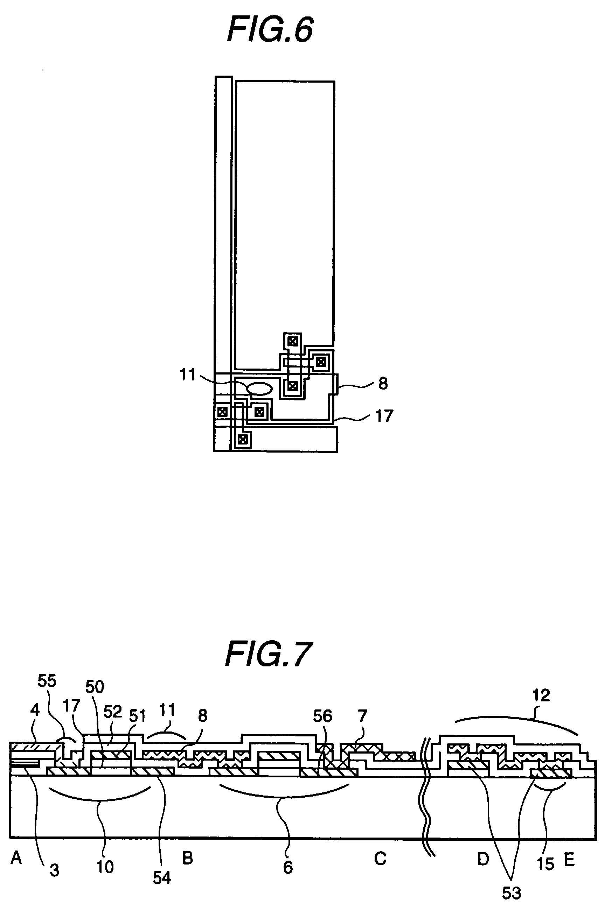

The mask patterns and the cross-sectional structure of the pixel shown in Fig.2 are shown in Figs.5 to 11. Figs.5 to 7 shows examples of appliance to a TFT with a coplaner structure. Figs.5 and 6 show the configuration of a mask for the pixel portion with thecoplaner structure. Fig.7 shows sections of the coplaner structure taken along an A - B line and a C - D line in Fig.5. The process for forming the TFT substrate will be briefly explained.

Firstly, silicon film is formed by using a LPCVD method, and poly-crystalized by performing a thermal annealing approximately at 500 to 600 °C and for 20 to 100 hours. After then, an island Si pattern of the TFT portions 10 and 11 are formed by the patterning. The resultant layers are used also lower electrodes 54 of the sampling capacitor 11. Next, the insulating film 16 or $SiO_2$ film is formed by using an APCVD method, and then a gate Si layer of the TFT portion is formed by using the LPCVD method. After then, a gate portion 51 of the TFT portions 10 and 11 is formed by dry-etching two $SiO_2$ films.

The dopant such as phosphorous ion is implanted in a source, a drain and the gate Si layer of the island Si pattern by using an ion implantation method. The source, the drain and the gate Si layer is activated by the heat treatment, and changed to an n type Si with low resistance. After then, a protecting film 52 for the TFT or $SiO_2$ film is formed, a first contact hole 53 is formed, and the scanning electrode 3 and a connection 12 are formed by using a metal film such as Cr. After the island pattern is formed in the connection 56 to the display electrode, the transparent electrode 7 is formed by ITO. It is, therefore, possible to decrease the connection resistance to the ITO. After then, an inter-layer insulating layer 17 or $SiO_2$ film is formed, and a second contact hole is formed. Finally, the TFT substrate is completed by forming the signal electrode 4. The above process is a low temperature poly-Si TFT process. However, it should be appreciated that a high temperature poly-Si TFT process can be also used instead. By using this process, it is possible to obtain a TFT with the superior mobility and miniature the TFT. Further, there is an advantage in incorporating easily the peripheral circuit such as a scanning wire selecting circuit in the TFT. In the mask pattern shown in Figs.5 and 6, both of the sampling TFT 10 and the pixel driving TFT 6 have a coplaner structure. The sampling capacitor is formed between the island Si 50 of the source electrode of the sampling TFT 10 and the metal wire of the common electrode through the protecting film for the TFT. The Si island and the gate electrode layer are connected by the contact hole 15 through the connection 12. Therefore, the sampling capacitor can be formed so as to incorporate the whole source region of the sampling TFT.

In Fig.6, the sampling capacitor 11 is configured by patterning the layer of the signal electrode and the common electrode 8 like an island. All of the electrodes of the capacitor are formed by a metal film. While the area of the sampling capacitor becomes smaller than that of Fig.5, the resistance of an electrode is smaller than it. It is, therefore, possible to write fast in a capacitor.

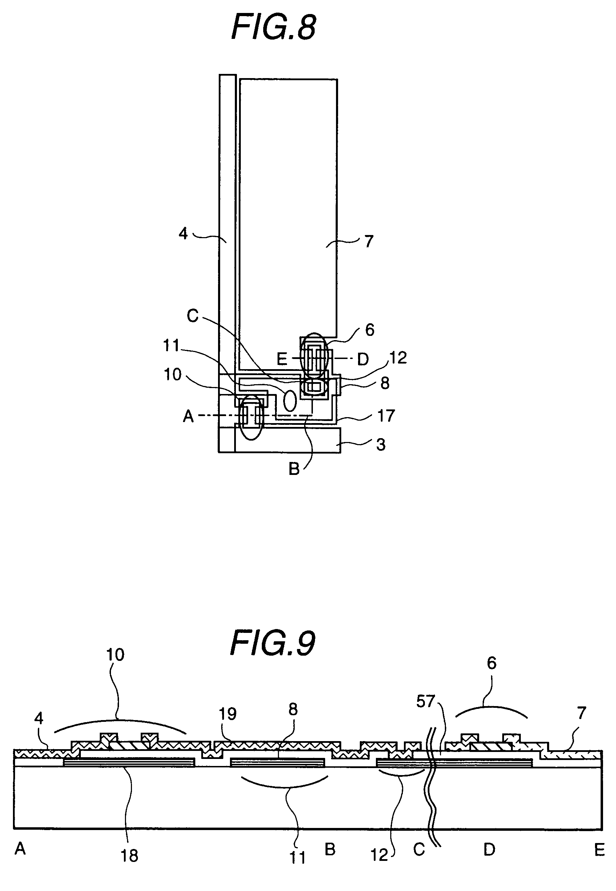

Figs.8 shows the configuration of the mask for the pixel portion with the inverse stagger structure, and Fig.9 shows the cross section of A-B-C-D-E portions of the inverse stagger structure shown in Fig.8. Because of the inverse stagger structure, the gate electrode 18 of the TFT exists on the lowest layer. The sampling capacitor 11 is formed between the common electrode 8 and the source electrode 19 of the sampling capacitor. By adopting such structure, the insulating film of the sampling capacitor can be commonly used with a protection insulating film 57 of the sampling TFT. Therefore, it is possible to simplify the manufacturing process, and it is suitable for a mass production in the currently main product.

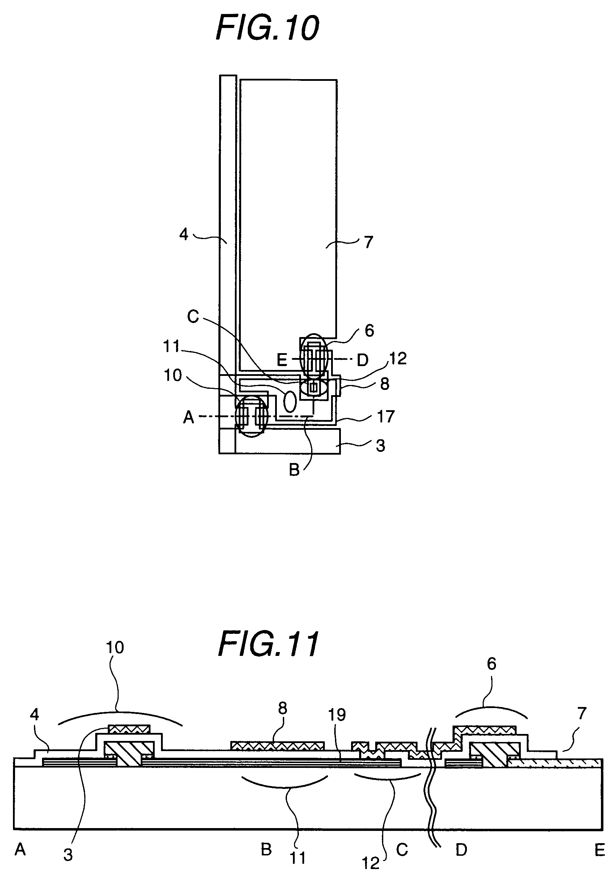

Fig.10 shows the configuration of the mask for the pixel portion with the stagger structure, and Fig.11 shows the cross section of A-B-C-D-E portions of the stagger structure shown in Fig.10. Because of the stagger structure, the gate electrode is on the top surface. The sampling capacitor is formed like the inverse stagger structure between the common electrode 8 and the source electrode 19 of the sampling capacitor. The manufacturing process is as follows. Firstly, the signal electrode 4 and the transparent electrode 7 are formed, and then the patterning is performed independently. The semiconductor layer, n-Si layer is formed by using a PE-CVD method. After the patterning, the i-Si layer and the silicon nitride layer are formed and the patterning is performed. After then, the scanning electrode and the common electrode are formed and the patterning is performed. Because more than five times exposure is not required, the manufacturing can be simplified.

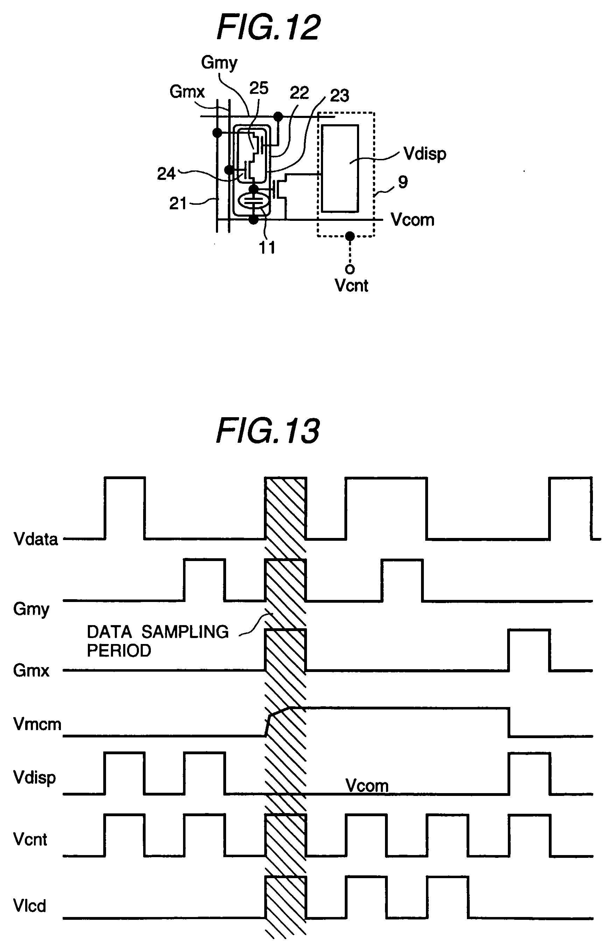

Fig.12 shows another embodiment of the present invention. In this embodiment, a plurality of scanning electrodes (Gm) of the display portion is arranged in x-y matrix, in addition to the embodiment of the pixel portions shown in Fig.1. Namely, there are provided a y-directional scanning electrode Gmy for identifying the y-directional position of the pixel, and an x-directional scanning electrode Gmx for identifying the x-directional position of the pixel. A specified one pixel is selected by using these electrodes. The scanning wire selecting circuits are provided along two sides of the display portion, for example, the right side and the bottom side, so as to correspond to matrix-like scanning wires Gmx and Gmy. as shown in Fig.1. The pixel includes an address decoder 23 having x-directional scanning electrode decoder TFT 24 and y-directional scanning electrode decoder TFT 25 connected in series with the decoder TFT 24, and the signal electrode 21. When a high level voltage is applied to both the x-directional and the y-directional electrodes, and thus both the x-directional scanning electrode decoder TFT 24 and y-directional scanning electrode decoder TFT 25 turn to "ON", the signal electrode 21 and the sampling capacitor are connected to each other, and a signal data voltage Vdata indicative of the state of "ON" or "OFF" of the pixel by using the high or low voltage applied from the signal electrode is charged in the sampling capacitor. Driving signals applied to the pixel portion shown in Fig.12 will be explained hereinafter with reference to Fig.13.

The voltages of both of the x-directional scanning electrode Gmx and y-directional scanning electrode Gmy, each connected to the pixel of which the display is rewritten turn to the high level, and thereby the pixel turns to a selected state. The sampling capacitor of the selected pixel is connected to the signal wire 21. An inter-terminal voltage Vmem of the sampling capacitor of each of the selected pixel is charged up to Vdata by the voltage applied to the signal wire. If the Vmem is more than the threshold voltage, the pixel driving TFT turns to a "ON" state and the driving voltage is applied to the liquid crystal as in the case of the above embodiment. Otherwise, the driving voltage is not applied to the liquid crystal. Because the non-selected pixel can not allow the TFTs in the address decorder to turn to "ON", the inter-terminal voltage of the sampling capacity in the pixel does not change, and thus the display is not rewritten.

As compared with the previous embodiment, while the rewrite of the display in the first embodiment is performed by selecting a row of pixels connected to one x-directional scanning electrode at the same time, only one selected pixel can be rewritten in this embodiment. Therefore, it becomes possible partially to rewrite in a unit of pixel. Furthermore, the control is not necessary except controlling the x-directional and y-directional scanning electrodes and the data wiring. It is, therefore, easy to control the display of the panel.

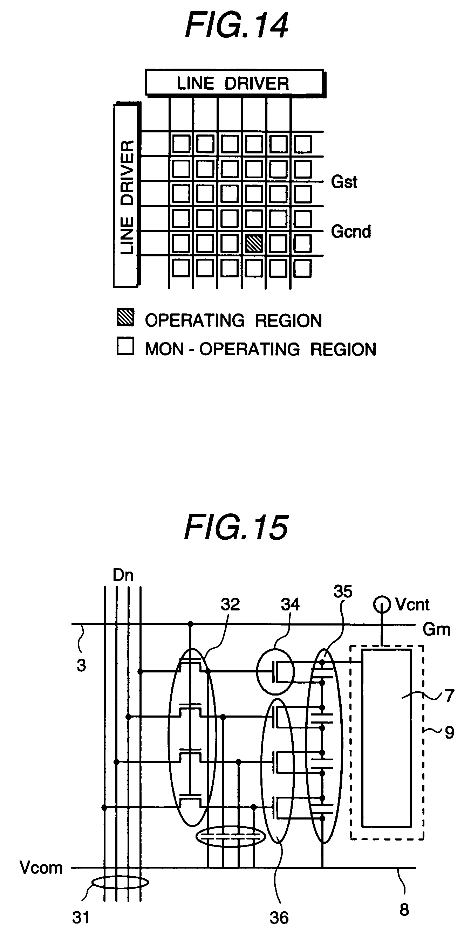

Fig.15 shows the configuration of the pixel portion with gray level selecting TFTs according to a third embodiment. The pixel portion includes a plurality of signal electrodes 31, the scanning electrode 3, the common electrode 8, a plurality of sampling TFTs 32 for changing the gray levels, a sampling capacitor 33, a plurality of gray level selecting TFTs 36, a row of voltage-dividing capacitors 35, and the opposed electrode 9.

Gate electrodes of the sampling TFTs are connected to the scanning electrode. Drains and sources of the sampling TFTs are connected to a plurality of data wires each provided independently of others and sampling capacitors each provided independently of others, respectively. One terminal of each of the sampling capacitors is the common electrode. The terminals of the capacitors connected to the sampling TFT are connected to gates of a plurality of display selecting TFTs 34 and a plurality of gray level selecting TFTs 36. Drain and source of each of these TFTs are connected to each of the voltage-dividing capacitors so as to short-circuit each of the voltage-dividing capacitors.

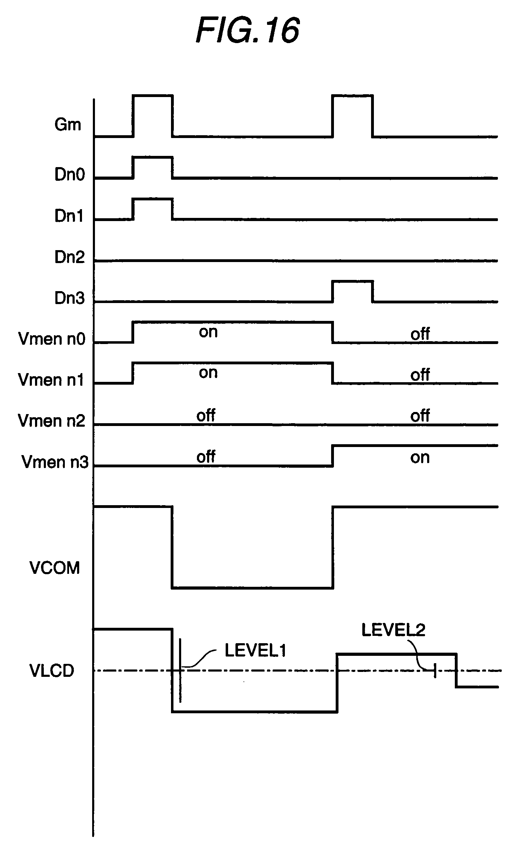

Fig.16 is a wave form chart of the driving signals applied to the pixel portion shown in Fig.15.

When the pixel selecting pulse is applied to the scanning electrode, one line of pixels are selected at the same time. A plurality of sampling TFT within the pixel turn to the ON state at the same time. As a result, the sampling capacitors are charged by the voltages of the signal electrodes, respectively, and thus Vmem n0 is changed. Until the scanning electrode becomes a high level next, Vmem n3 is held with the sampling capacitors. The above operation is the same as the embodiment 1.

At this time, respective display selecting TFTs 34 and gray level selecting TFTs 36 turn to the ON states due to the sampling capacitors which a voltage Vmem higher than the threshold voltage of the display selecting TFT 34 and the plurality of gray level selecting TFT 36 was applied, and a row of capacitors each of which is connected in parallel are short-circuited. When the display selecting TFT 34 is not selected, the transparent electrode 7 and the capacitors are insulated. Therefore, since an alternating voltage applied from the opposed electrode is not applied to the liquid crystal, the liquid crystal is not driven. In order to display gray levels, the gray level data made by the combination of a high voltage of the signal electrode with a low voltage is applied to the sampling capacitors. Some of the row of capacitors are short-circuited due to the combination of the voltage values, and thus the combined capacity of these capacitors changes.

The capacity of the liquid crystal formed between the display electrode and the opposed electrode is connected in series with the row of capacitors. A voltage of a liquid crystal driving power source Vcnt is applied between the common electrodes and the opposed electrode. Therefore, the liquid crystal driving voltage applied to the liquid crystal layer is divided by the combined capacity changed by the display data of the capacitor row and the liquid crystal capacity. Therefore, since the liquid crystal applying voltage changes when the combined capacity of the capacitor row changes due to the gray level data, it becomes possible to display the gray levels. As described above, it becomes possible to change in stages the liquid crystal applying voltage, and thus obtain multiple-gray-level display.

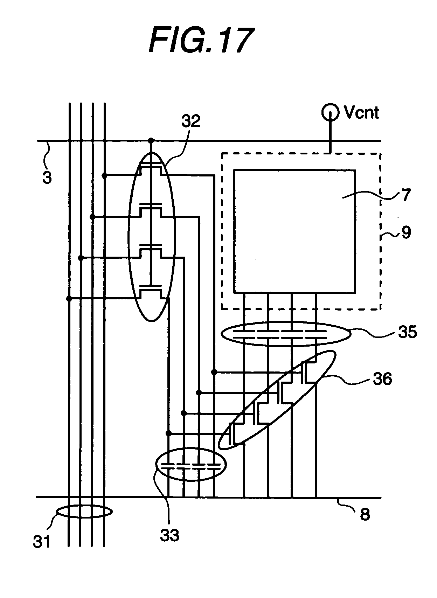

Fig.17 shows another embodiment of the liquid crystal display apparatus which can display the gray levels. In this embodiment, the row of voltage dividing capacitors 35 are connected between and in parallel with the transparent electrode 7 and the common electrodes 8, and a gray level selecting TFTs 36 are inserted between respective capacitors and the common electrodes. Because the gray level selecting TFT can be driven reliably by using the above configuration, even if the voltages of the sampling capacitors 33 are low, it is possible to allow the voltage of the signal electrode to be low. Therefore, it becomes possible to decrease the operation voltage of the panel, and reduce the power consumption.

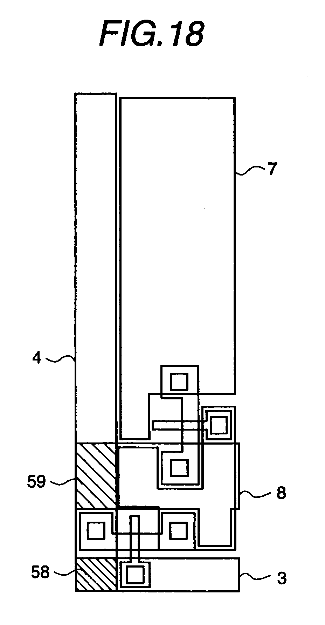

Fig.18 shows another embodiment of the pixel portion used in the present invention. The pixel shown in Fig.18 has the same configuration as that shown in Figs.5 and 6. In this embodiment, the relationship between the capacity of the liquid crystal and that of the intersecting portion can be defined by the following equation. Where, the liquid crystal capacity is an electrostatic capacity formed by the configuration in which the liquid crystal is sandwiched between each electrode and the electrode counter to the TFT substrate (not shown), and the intersecting portion capacity is the sum of the capacity formed at a wire intersecting portion 59 of the signal electrode 4 and the common electrode 8 and the capacity formed at a wire intersecting portion 58 of the signal electrode 4 and the scanning electrode 3.

liquid crystal < (signal electrode capacity + wire intersecting portion capacity ) x the number of scanning wires

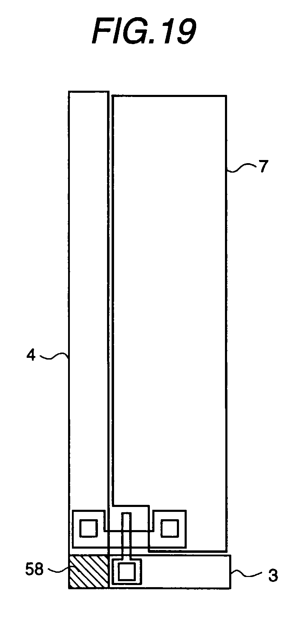

It becomes possible to reduce the power consumption when the content of the display is not rewritten, relative to the prior art having the same wire intersecting portion 58 as that shown in Fig.19, by defining the above relationship.

The above definition will be explained in detail hereinafter, based on the embodiment shown in Fig.18.

In the pixel having the configuration shown in Fig.5, most of the electric power consumed in the pixel is the loss occurred during the charge and discharge of the parasitic capacity of respective wires. Assuming that a capacitor C (F) repeatedly charges and discharges at a square wave with the amplitude voltage V (V) and the repetition frequency f (Hz). The power consumption P (W) is proportional to the square of the amplitude voltage and the frequency, and represented by the following equation.

$$P = C \times V \times V \times f$$

Assuming that the capacity of the opposed electrode and each of the scanning electrode, the signal electrode, the common electrode and the display electrode are, respectively, CDLC, CGLC, CCOMLC, CPXLC. The electrostatic capacity between the electrodes formed on the TFT substrate and the opposed electrode formed on the substrate counter to their electrode via the liquid crystal are as follows.

$$CDLC = \varepsilon \times \varepsilon\, LC \times SD \div tLC$$

$$CGLC = \varepsilon \times \varepsilon\, LC \times SG \div tLC$$

$$CCOMLC = \varepsilon \times \varepsilon\, LC \times SCOM \div tLC$$

$$CPXLC = \varepsilon \times \varepsilon\, LC \times SPX \div tL$$

where, $\varepsilon$ is vacuum dielectric constant, $\varepsilon$ LC is relative dielectric constant of liquid crystal, SD is area of pixel electrode, SG is area of scanning electrode, SCOM is area of common electrode, SPX is area of pixel electrode, and tLC is thickness of liquid crystal cell.

Assuming that the intersecting portion capacity of the scanning electrode for a pixel and the signal electrode, and that of the common electrode and the signal electrode are CGDcross 58 and CDCOMcross 59, respectively. Each capacity is represented by the following equation.

$$CGDcross = \varepsilon \times \varepsilon\, ins \times SGD \div tins$$

$$CDCOMcross = \varepsilon \times \varepsilon\, ins \times SDCOM \div tins$$

Next, the loss of the electric power due to the charge and discharge of these capacity will be calculated. When the display is not rewritten in the panel of the present invention, the voltages of the scan electrode and the signal electrode on the TFT substrate are maintained to be constant, and thus the pulse wave is not applied. Therefore, the alternating voltage for driving these capacity is only the liquid crystal driving voltage with the amplitude VLC and the frequency f(LC) applied from the opposed electrode due to CGLC, CDLC, CcomLC, and CpxLC. Accordingly, the power consumption PLC of the liquid crystal system, that is, the sum of the power consumed in respective capacity, is as follows.

$$PLC = \{CGLC + CDLC + CcomLC + CpxLC\} \times VLC \times VLC \times f(LC)$$

Concretely, assuming that a TN liquid crystal is used, the threshold voltage of the liquid crystal is 3 V, its saturation voltage is 8 V and the threshold voltage of the TFT is 2 V, the VLC is approximately 15 V. Further, when the frame frequency is 60 Hz, the liquid crystal can work at f(LC) = 30 Hz. Further, because it is not necessary to write the display data into the pixel every frames in the present invention, the alternating wave form is not applied to the scan electrodes and the signal electrodes, and thus the power loss due to the charge and discharge does not occur.

On the other hand, the prior art of Fig.19 has the capacities formed between the opposed electrode and each of the scanning electrode, the signal electrode, and the display electrode, as an electrostatic capacity which generates the loss of electric power. Assuming that the capacities per one pixel formed between these electrodes is CGLC, CDLC and CPXLC, respectively, the value of each of the capacities is represented by the following equation.

$$CDLC = \varepsilon \times \varepsilon\, LC \times SD \div tLC$$

$$CGLC = \varepsilon \times \varepsilon\, LC \times SG \div tLC$$

$$CPXLC = \varepsilon \times \varepsilon\, LC \times SPX \div tLC$$

The pulse wave form with the voltage value VG(V) is applied one time to the scanning electrode every frame frequency f(flm) corresponding to the frame frequency of 60 HZ. The amplitude of the voltage is VG. Because it is necessary to set the VG to a voltage higher than the sum of the liquid crystal applying voltage VLC and the threshold voltage of the TFT in general, it is necessary to set the VG to 20 V if VLC = 15 V. Further, an alternating voltage which changes its value every horizontal scanning frequency f(H) defined by the following equation is applied to the signal electrodes. The amplitude of the applied voltage is the same as the liquid crystal driving voltage VLC.

$$(Horizontal\ frequency) = (frame\ frequency) \times (number\ of\ scanning\ signal)$$

Concretely, when the frame frequency is 60 Hz and the number of scanning signal is 480, the horizontal frequency 28.8 kHz.

The voltage applied to the display electrode is the alternating liquid crystal driving voltage of which the polarity is inverted every frame frequency. The driving frequency is 30 Hz {f(LC)}, half of the frame frequency, and the voltage is VLC.

The power loss due to the charge and discharge of the capacity of the liquid crystal is calculated by the following equation.

$$PLC(prior\ art) = CpxLC \times VLC \times VLC \times f(LC) + CGLC \times VG \times VG \times f(flm) + CDLC \times VLC \times VLC \times f(H)$$

The voltage at the intersecting portion of the signal electrode and the scanning electrode becomes a difference voltage between the voltages of the electrodes. Therefore, the power loss is calculated according to the following equation.

$$Pcross(prior\ art) = CGDcross \times [\{VLC \times VLC \times f(H)\} + \{VG \times VG \times f(flm)\}]$$

The sum P(prior art) of the power loss, that is, the sum of PLC(prior art) and Pcross(prior art) is,

$$P(prior\ art) = CpxLC \times VLC \times VLC \times f(LC) + CGLC \times VG \times VG \times f(flm) + CDLC \times VLC \times VLC \times f(H)$$
$$CGDcross \times [\{VLC \times VLC \times f(H)\} + \{VG \times VG \times f(flm)\}]$$
$$= (CDLC + CGDcross)VLC \times VLC \times f(H + (CGLC + CGDcross) \times VG \times VG \times f(flm)$$
$$+ (CpxLC) \times VLC \times VLC \times f(LC)$$

Substituting the real number within the range of the actual use in the above equation, the horizontal frequency 28.8 kHz when the frame frequency is 60 Hz and the number of the scanning wires is 480. Assuming that the TN liquid crystal is used as the liquid crystal, the threshold voltage of the liquid crystal is 3V, the saturation voltage is 8V, and the threshold voltage of the TFT is 2V, the VLC is approximately 15V. Further, f(LC) operates at 30 Hz when the frame frequency is 60 Hz. Accordingly, the above equation is,

$$P(prior\ art) = (CDLC + CGDcross) \times 6480000 + (CGLC + CGDcross) \times 1200 + (CpxLC) \times 6750$$

where, a first and a second term are negligible. Therefore, P(prior art) becomes the following equation in the actual use.

$$P(prior\ art) = (CDLC + CGDcross)VLC \times VLC \times f(H)$$

It is possible to reduce the loss of the driving power as compared with the prior art, by setting the PLC(invention) to a value less than the above electric power in this embodiment. The following equation represents how to obtain such the value.

$$PLC(invention) = P(prior\ art)$$

$$(CGLC + CDLC + CcomLC + CpxLC) \times VLC \times VLC \times f(LC)$$

$$< (CDLC + CGDcross) \times VLC \times VLC \times f(H)$$

Namely,

$$(CGLC + CDLC + CcomLC + CpxLC) \times f(LC)$$

$$< (CDLC + CGDcross) f(H$$

Since f(H) = f(LC) x (number of scanning electrodes) , the above equation is rearranged as follows.

$$(CGLC + CDLC + CcomLC + CpxLC) \times f(LC)$$

$$< (CDLC + CGDcross) \times f(LC) \times (number\ of\ scanning\ electrodes)$$

Dividing both sides of the equation by f(LC),

$$(CGLC + CDLC + CcomLC + CpxLC)$$

$$< (CDLC + CGDcross) \times (number\ of\ scanning\ electrodes)$$

where, the term (CGLC + CDLC + CcomLC + CpxLC) of the left side represents the sum of the capacities between the opposed electrode and each of the scanning electrode, signal electrode, and display electrode, and the term (CDLC + CGDcross) of the right side represents the sum of the capacity between the signal electrode and the opposed electrode and the capacity at the wire intersecting portion between the signal electrode and the scanning electrode.

Therefore, If the above equation satisfies the following condition , it is possible to obtain the improved panel of which the power consumption is less than that of the prior art.

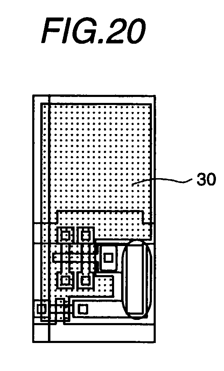

Fig.20 shows the configuration of the mask for the pixel portion with a reflection electrode used in the present invention. While the configuration of the pixel itself is the same as that in the first to the third embodiments, this embodiment is characterized by the use of the reflection electrode.

Because the reflection electrode can be laid overlapping with the TFT, the component of the pixel, and the wires by electrically insulating from them, it is possible to enlarge more the region of display.

If a reflection type of pixel with a high aperture ratio is constructed in the prior art, the display electrode must be overlapped with the scanning electrode and signal electrode. In such a case, since the capacity connection is formed between the display electrode and each of the signal electrode and the scanning electrode, it is difficult to display correctly the voltage held in the display electrode of the pixel. This is because the display electrode performing a holding operation is electrically insulated from any of the electrodes, and the voltage of the display electrode is affected by the pulse voltage applied to the scanning electrode and the signal electrode.

However, because the selected display electrode is connected to the common electrode through the pixel driving TFT, the voltage of the display electrode is not affected, due to the capacity coupling of the scanning electrode with the signal electrode. As a result, the optimum display can be obtained.

Further, because it is impossible directly to see a lower portion of the display electrode which forms a shadow, from the front of the panel, the light emission to a TFT is remarkably reduced by laying the TFT at that position. If the apparatus is used at the outside, a strong light may remarkably increase an OFF current of the TFT in the apparatus, and thus deteriorate the characteristic of display of the apparatus. It is possible to avoid the increase in the OFF current by adopting the configuration according to the present embodiment. Particularly, in a reflection type panel with low power consumption suitable for a panel of a portable device, it is possible effectively to improve the increase in the OFF current of the TFT. Further, because in the reflection type panel it is unnecessary to use the back light with high power consumption, it becomes possible remarkably to reduce the power consumption by adopting the present invention to the reflection type panel.

The manufacturing process of the above panel will be explained next.

In the cross-sectional structure shown in Fig.7, an insulation layer is formed on a surface of the configuration by using a insulation material such as SiO2 or Si3N4 after forming the scanning electrodes. A contact hole is formed to connect the display electrode to the pixel driving TFT 6, a metal film such as Al or silver with high reflection factor is formed, and then the patterning is performed. It should be noted that in order to increase the reflection factor, it is effective to carry out the above process after eliminating uneven spots on the surface by using the planerization technique such as fine polishing, after the insulation layer is formed.

In this case, it is necessary to use a guest-host type liquid crystal in which the dye is dispersed as a liquid crystal, and use a display mode in which the superior contrast can be obtained in a reflective display mode. It should be noted that the PCGH mode also can be applicable to. It can combine the above liquid crystal with the polymer dispersion liquid crystal. The polymer dispersion liquid crystal has an advantage in manufacturing equally a large panel, because it is fixed by the solid resin or the resin with high viscosity.

According to the above-mentioned embodiment, it can store the display information within the pixel, and it is not necessary to drive the display electrode and signal electrode if the display is not rewritten. Therefore, it is possible to reduce the power consumption of the panel.

It is further possible to rewritten the display every one pixel by providing the pixel address selecting means within the pixel. Therefore, the power consumption can be reduced. In addition, because it can manage the display device as a bit map memory, the management of the display can be remarkably simplified.

Furthermore, it can control the voltage to be applied to the display electrode due to a plurality of display information stored in the pixel. It is, therefore, possible to obtain improved display in multiple gray levels, and obtain color display by combining a color filter.

FIG. 20 is a schematic diagram of the whole structure of the liquid crystal display apparatus showing one embodiment of the present invention. In FIG. 20, the liquid crystal display apparatus is formed as a TFT active matrix type liquid crystal display, comprise a pixel circuit 100, a display part 110, a signal circuit 200, a scanning circuit 300, an AC voltage circuit 400, a timing circuit 500, a center voltage circuit 600, a counter board 700 and a TFT board 800, in which the pixel circuit 100, the display part 110. the signal circuit 200, the scanning circuit 300 and the counter board and the TFT board 800 are formed on the color panel P. In the present embodiment shown by FIG. 1, what is only shown is the color panel P and its peripheral circuits, and the detail structure of the color panel P such as optical system is not shown.

The color panel P has a pair of boards, the counter board 700 and the TFT board 800, in which the individual boards are so laid out that the liquid crystal layer (not shown) including liquid crystals forming a plurality of pixels may be inserted between these boards 700 and 800, and that the individual boards may face to each other. The counter board is a transparent plate and a transparent electrode is formed on one side of the board. On the TFT board 800, the pixel circuit 100, the display part 110, the signal circuit 200 and the scanning circuit 300 are formed. The pixel circuits are formed on the display part 100 as an n x m matrix. The n scanning wires G1 to Gn are developed uniformly on the display part 110, and the m signal wires D1 to Dm crossing to the scanning wires perpendicularly are developed uniformly as well. On the display surface of the color panel P, on the display part 110 forming a display area, a plurality of display areas A11 to Anm are formed, each display area defined by a single scanning wire and a single signal wire. For example, assuming that the number of the scanning wire is 640 and the number of signal wires is 480, the color panel P can be established with 640 x 480 pixel dots. For the individual display area, the AC signal wire CP, the timing line TMG and the reference line CNT are connected to the individual display area, and the AC signal wire CP is connected to the AC voltage circuit 400, the timing line TMG is connected to the timing circuit 500, and the reference line CNT is connected to the center voltage circuit 600.

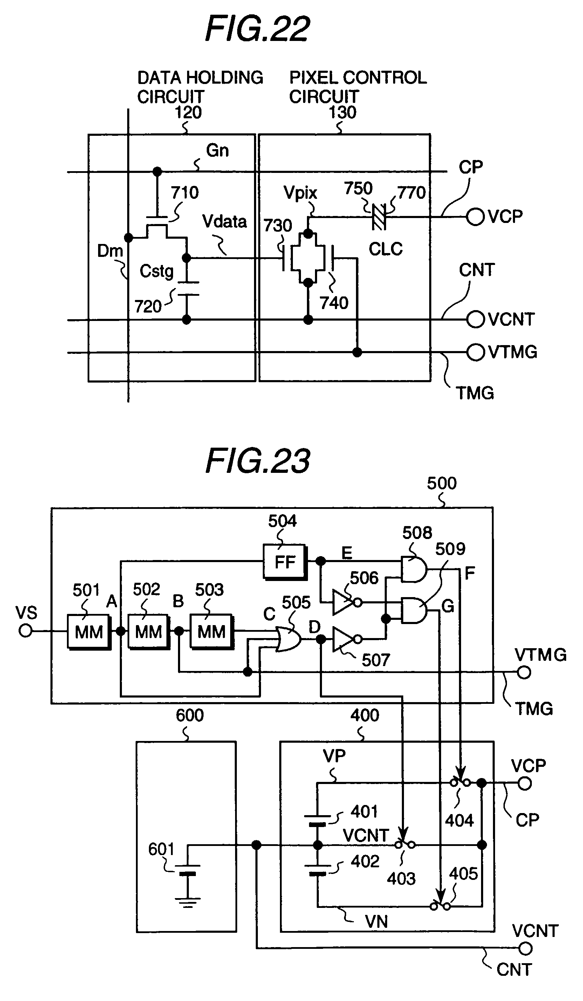

As shown in FIG. 22, the pixel circuit 100 defined in the individual display comprises a data hold circuit 120 and a pixel control circuit 130. The data hold circuit 120 comprises a transistor 710 composed of TFT and holding capacitance 720, and the pixel control circuit 130 comprises transistors 730 and 740 composed of TFT, a display electrode 740 and a transparent electrode 770. For the pixel circuit 100 located at the n-th raw and the m-th column, the scanning wire Gn is connected to the gate of the transistor 710 and its drain is connected to the signal wire Dm, and its source is connected to the gate of the transistor 730 and one of the terminals of the holding capacitance 720. The other terminal of the holding capacitance 20 is connected to the reference line CNT. The transistors 730 and 740 are connected in parallel, in which their drains are connected to their sources mutually, and each drain is connected to the display electrode 770, and each source is connected to reference line CNT. The gate of the transistor 740 is connected to the timing line TMG. The liquid crystal capacity CLC is formed between the display electrode 750 and the opposed electrode 770, and the opposed electrode is connected to the AC signal wire CP.

The transistor 710 is turned on when the level of the scan pulse applied to the scanning wire Gn is "H", and then, captures the image data transferred on the signal wire Dm, and thus, the voltage Vdata in responsive to the image data is applied to the gate of the transistor 730 and Vdata is so charged in the holding capacitance 720. The transistor 730 is turned on when the level of Vdata is "H", and works as a pixel driving switching device for applying the charged voltage stored in the holding capacitor 720 to the display electrode 750. The transistor 740 is turned on when the level of the timing signal for transmitting the signal on the timing line TMG is "H", and makes short between the drain and the source of the transistor 730, and the voltage between the display electrode 50 and the opposed electrode 770 is initialized to 0 V when the transistor 730 is turned off. Thus, the transistor 730 is used as a reset means. In addition, the signal circuit 200 is formed as a image data generation means for applying the image data onto the individual signal wires D1 to Dm, and the scanning circuit 300 is formed as a scan pulse generation means for applying the scan pulses sequentially to the individual scanning wires G1 to Gn.

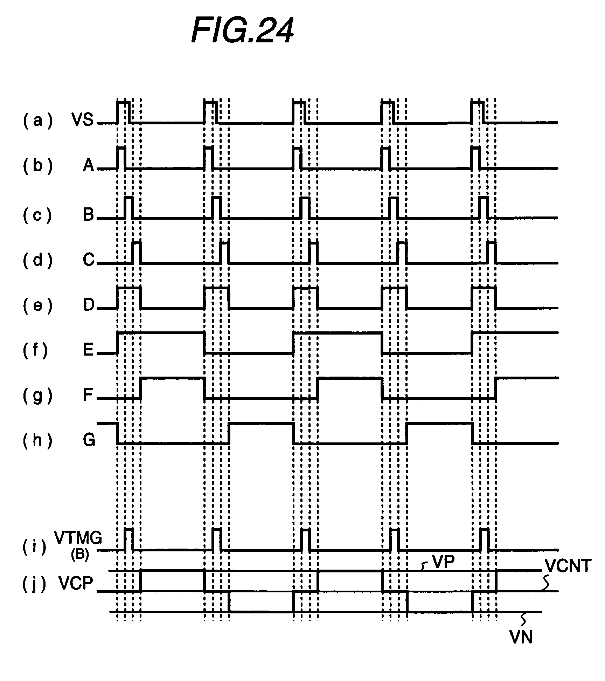

Next, by referring to FIG. 23 and FIG. 24, the detail structures of the AC voltage circuit 400, the timing circuit 500 and the center voltage circuit 600 are described.

The timing circuit 500 is composed of mono-stable multi-vibrators 501, 502 and 503, a flip-flop 504, an OR gate 505, inverters 506 and 507, and AND gates 508 and 509. The synchronous signal VS synchronized with the signal defining the frame frequency is applied to the input terminal of the timing circuit 750, and the timing signal VTMG including 760 Hz AC component is extracted from its output terminal.

When the synchronous signal VS is put into the vibrator 501, pulses with their pulse width specified by the individual multivibrator in responsive to the leading edge of the individual input pulse are put out from the individual output terminals A, B and C of the vibrators 501, 502 and 503, respectively, as shown in FIG. 24 (b) to (d). Pulses with their phase delayed by their single pulse width with respect to their output pulses are put out from the individual multi-vibrators 501 to 503, and each pulse is put into the OR gate 505. Therefore, as shown in FIG. 24 (e), the output pulse obtained by logical OR processing of input pulses is put out from the output terminal D of the OR gate 505.

On the other hand, the output pulse from the vibrator 501 is supplied to the flip-flop 504, and the pulse with its pulse width so shown as in FIG. 24 (f) is put out from the output terminal E of the flip-flop 504. Thus, the flip-flop 504 reverts its output signal at the timing when the synchronous signal VS rises up, and supplies sequentially the pulses with its logic value inverted every time when the synchronous signal VS arises. The output pulse from the flip-flop 504 is put into the AND gate 508, and at the same time, its output pulse reaches the AND gate 509 through the inverter 506. The output pulse from the OR gate 505 is put into the other input terminals of the AND gates 508 and 509 through the inverter 507. Therefore, the output pulse obtained by logical AND processing of the output pulse from the flip-flop 504 and the output pulse from the inverter 507 is put out from the output terminal F of the AND gate 508, and the output signal obtained by logical AND processing of the output pulse from the inverter 506 and the output pulse of the inverter 507 is put out from the output terminal G of the AND gate 509. Finally, the output pulses from the individual output terminals D, F and G are put into the AC voltage circuit 400, respectively. Thus, the timing circuit 500 is so configured as a timing signal generation means for supplying high-level pulses periodically.

The AC voltage circuit 400 is so configured as to comprise power supplies 401 and 402, and switches 403, 404 and 405, in which the connection point between the power supplies 401 and 402 defined as a reference line CNT is connected to the power supply 601 of the center voltage circuit 600. The positive terminal of the power supply 401 is connected to the AC signal wire CP through the switch 404, and the negative terminal of the power supply 402 is connected to the AC signal wire CP through the switch 405, and the connection point between the power supplies 401 and 402 is connected to the AC signal wire CP through the switch 403.

The switch 403 is so defined as to close its switching gate when the signal level of the output pulse from the output terminal D of the OR gate 505 is "H"; the switch 404 is so defined as to close its switching gate when the signal level of the output pulse from the output terminal F of the AND gate 508; and the switch 405 is so defined as to close its switching gate when the signal level of the output pulse from the output terminal G of the AND gate 509 is "H". As shown in FIG. 24 (j), when the signal including the reference voltage corresponding to the output voltage of the power supply 601 or including the center voltage VCNT is put out and then the switch 404 is closed, the voltage VP obtained by adding the output voltage of the power supply 601 to the output voltage of the power supply 401 is put out; and when the switch 405 is closed, the output voltage VN (negative voltage) of the power supply 402 is put out.

Thus, the AC voltage circuit 400 is so defined as an AC voltage generation means for applying the liquid-crystal driving voltage to the opposed electrode, in which the liquid-crystal driving voltage is obtained as and a minimum value VN, and for example, with its effective value 3V. As for the AC voltage VCP, the positive voltage period VP and the negative voltage period VN between them the center voltage VCNT is defined are defined, the timing signal VTMG arises while the VCP takes the center voltage VCNT value.

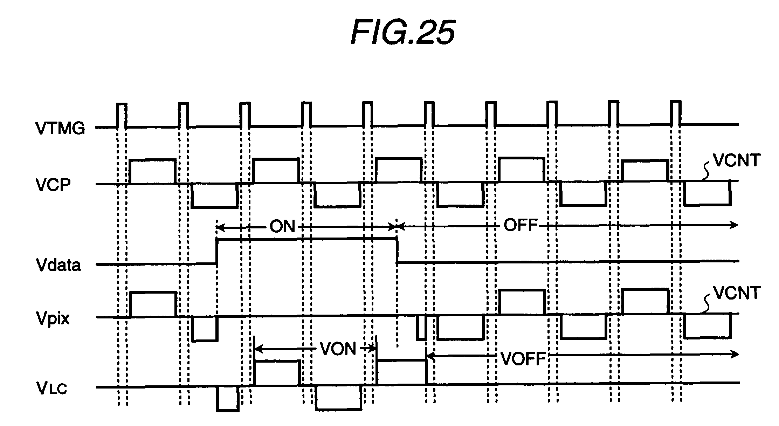

Next, referring to the timing chart shown in FIG. 25, the operation of the pixel circuit 100 is described. The period of the timing signal VTMG is defined as half of the period of the AC voltage signal VCP, in which the AC voltage VCP takes "H" when the timing signal VTMG is the center voltage value. In addition, the timing with which the voltage Vdata applied to the gate of the transistor 30 changes depends upon the writing operation of the data holding circuit 120, and the phase difference between Vdata and VCP changes with responsive to the position of the pixel even if signal synchronization between those voltage signals is taken. Therefore, for explanation, what is described is an example where data are altered at the almost center of the timing signal VTMG.

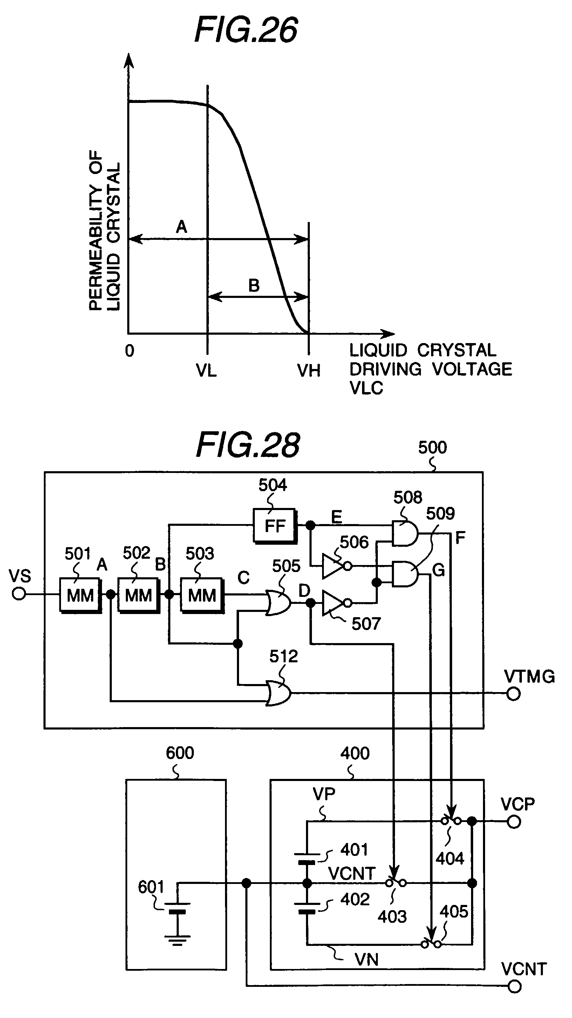

At first, the transistor 710 is turned on when the scan pulse is applied on the scanning line Gn, the image data is supplied through the signal wire Dm, and next, when the signal level of the voltage Vdata of the image data is "H", the transistor 730 is turned on and then, the voltage Vpix of the display electrode 750 gets to the VCNT equivalent to the reference voltage CNT. Thus, the AC voltage VCP as liquid crystal driving voltage VLC is applied directly to the liquid crystal between the display electrode 750 and the opposed electrode 750. Therefore, as shown in FIG. 26, the liquid crystal drive voltage VLC as effective value is applied to the liquid crystal, and its applied voltage (shown in the arrow A in FIG. 26) changes alternately between the saturation voltage VH (for the minimum liquid crystal transmittance) and 0V (for the maximum liquid crystal transmittance) with which the liquid crystal is turned on and off.

Next, when the signal level of Vdata changes from "H" to "L" and the timing signal VTMG is "L", the transistor 730 changes its state from "ON" to "OFF" while the state of the transistor 740 holds to be "OFF". As the result, the display electrode 750 becomes in the "OPEN" state in DC mode, and the liquid crystal drive voltage VLC becomes zero. However, there exists the liquid crystal capacitance CLC between the display electrode 750 and the opposed electrode 770, the voltage when the transistor 730 is at "ON" state is held in the liquid crystal capacitance CLC transitionally. Therefore, the voltage Vpix is held to be the central voltage VCNT, and the AC voltage VCP is applied to the liquid crystal.

After that, the level of Vdata changes from "H" to "L" and the level of the timing signal VTMG becomes "H", the transistor 740 changes into "ON" state. As the result, the display electrode 750 is made to be connected to the reference line CNT, and the electric charge stored in the liquid crystal transmittance capacitance CLC is discharged and the internal electric charge in the liquid crystal capacitance CLC is initialized to be zero. Thus, the voltage defined between the display electrode 750 and the opposed electrode 770 is initialized to be zero. As the result, the liquid crystal is immediately turned off, that is, light off, and then, as the transistors 730 and 740 is kept in an "OFF" state, even if AC voltage is applied to the opposed electrode 770, the electric charged in the liquid crystal capacitance CLC is kept to be zero, and the voltage Vpix of the display electrode 750 is equivalent to the voltage VCP of the opposed electrode 770. This leads to the fact that the liquid crystal applied voltage VLC is kept to be zero and that the liquid crystal is kept to be in a "light-off" state.

Thus, in this embodiment of the present invention, by means that the transistor 740 is made to be turned "On" periodically in responsive to the timing signal VTMG, and that the electric charge stored in the liquid crystal capacitance CLC is periodically initialized to be zero when Vdata is zero, the response of the liquid crystal drive voltage VLC with respect to the voltage Vdata can be made to be higher, and the animated image and the still image can be displayed in better condition when the animated image and the still image are displayed on the liquid crystal display panel in responsive to the supplied image data.

In the above described embodiment of the present invention, the period of the timing signal VTMG used for the initialization period is so defined as to be equal to half of the voltage VCP applied to the opposed electrode 770. However, the period of the timing signal VTMG can be extended within the allowable range with respect to the response delay of the liquid crystal drive voltage VLC. In this case, it may be allowed to make the wave form of the voltage VCP so that the center value of the intermediate value of the voltage VCP may be equivalent to the voltage VCNT at least when the timing signal VTMG is "H".

In the above embodiment, the period of the voltage VCP is selected to be 1/30 second. The period of the voltage VCP can be determined so as to be independent of the timing for writing data in the data hold circuit 120. In this case, though the period of the data writing timing of the data hold circuit 120 is subject to the length of data, the period of the voltage VCP can be fixed to be a certain period. In addition, the period of the voltage VCP correlates with the flicker operation and the device consumption power. In this circumstance, if the period of the voltage VCP is selected to be shorter, the consumption power increases while the flicker disturbance can be reduced due to the increasing of the flicker frequency. In contrast, if the period of the voltage VCP is selected to be longer, the flicker disturbance is emerged while the device consumption power can be reduced as the AC frequency for driving the liquid crystal is lower.

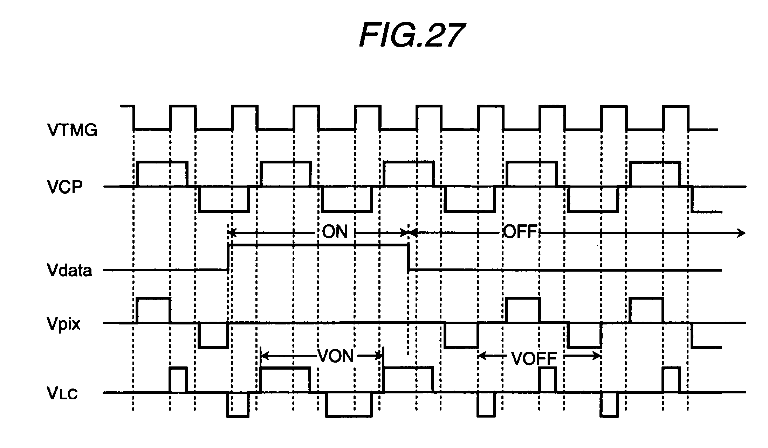

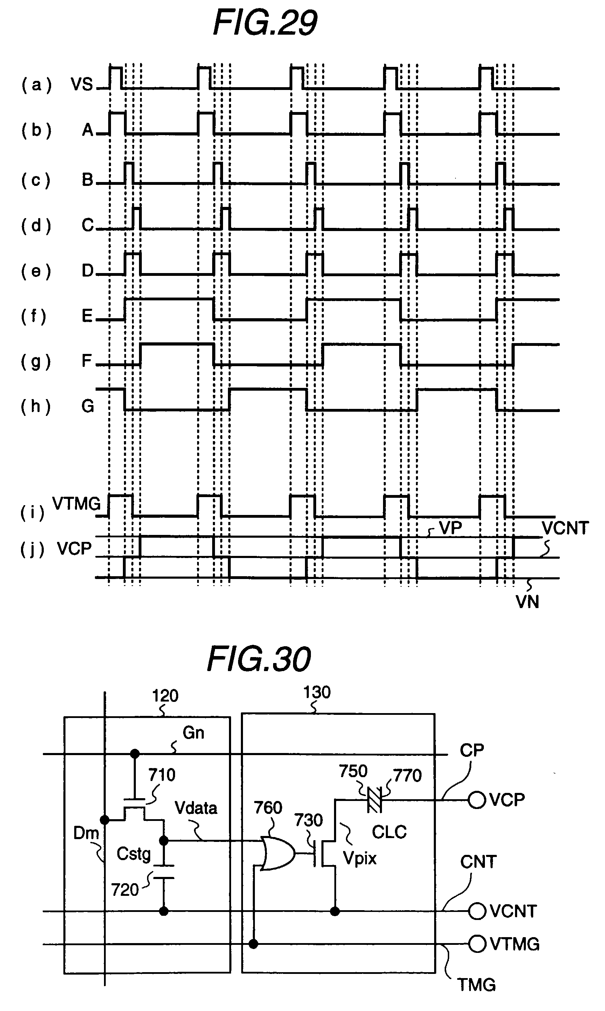

Next, another embodiment of the present invention is described by referring to FIGS. 27 and 29.

In this embodiment, the pulse width of the timing signal VTMG is shorter than the pulse width of the timing signal VTMG shown in FIG. 25. With this setting, even when the level of the voltage Vdata of the data hold circuit 120 is "L", the transistor 740 can be turned "ON" in a short period of time and thus, the liquid crystal applied voltage VLC is defined to be the voltage VL equivalent to the threshold value of the liquid crystal shown in FIG. 26.

As for the detail circuit structure, as shown in FIG. 28, OR gates 511 and 512 in stead of OR gate 505 in FIG. 23 are installed in the timing circuit 500, in which the output pulses from the multi-vibrators 502 and 503 are put into the OR gate 511, the output pulses from the multi-vibrators 501 and 502 are put into the OR gate 512, and the output pulse from the multivi-brator 502 is supplied to the flip-flop 504.

With the timing circuit 500 so configured as described above, as shown in FIG. 29, when the signal level at the output terminals A and B is "H", the timing signal VTMG becomes "H". As for the AC voltage VCP, when the signal level at the output terminal F is "H", the AC voltage VCP reaches its maximum value VP, and when the signal level at the output terminal G is "H", the AC voltage VCP reaches its minimum value VN. This means that the timing signal VTMG is so designed as to become "H" at the positive or negative timing with respect to the center voltage VCNT of the AC voltage VCP.

In the above circuit structure, when the voltage Vdata of the data hold circuit becomes "H" and then the transistor 30 is turned "ON", the voltage Vpix of the display electrode 50 becomes the center voltage VCNT, and the AC voltage VCP is applied directly to the liquid crystal and the liquid crystal lights on.

Next, the voltage Vdata changes from "H" to "L", and then, the transistors 30 and 40 are turned "OFF" together when the timing signal VTMG becomes "L". At this timing, the voltage Vpix is equivalent to the center voltage VCNT, and the voltage VCP is applied to the liquid crystal. After that, when the timing signal VTMG changes from "L" to "H", the transistor 740 is turned "ON", and then its voltage is directly to the liquid crystal if the level of the AC voltage VCP is different from the level of the voltage VCNT. In the state that the timing signal VTMG keeps in "H", when the level of the voltage VCP changed to the level of the center voltage VCNT, then the electrode 750 is made to be connected to the reference line CNT, and the electric charge of the liquid crystal capacitance (transmittance capacitance) CLC is initialized to be zero.

After this operation, in the state that the voltage Vdata is "L", when the timing signal VTNG changes "H" periodically, the transistor 740 is turned "ON" periodically when the level of the AC voltage VCP is in the level different from the level of the center voltage VCNT, and finally, as shown by the arrow B in FIG. 26, the voltage between the saturated voltage VH and the threshold voltage VL is applied to the liquid crystal as the liquid crystal drive voltage VLC, and the liquid crystal lights off.

In this embodiment, as the liquid crystal drive voltage VLC is so designed to be initialized periodically to be zero, the response of the liquid crystal drive voltage VLC with resp2ect to the change in the voltage Vdata can be increased, and hence, the smooth display operation of the animated image and the still image can be established. And furthermore, as the liquid crystal drive voltage VLC between the saturated voltage VH and the threshold voltage VL may be applied to the liquid crystal even when the voltage Vdata is "L", the response speed of the liquid crystal can be more increased than that in the previous embodiment. In case of applying this embodiment to the color display devices, as the white balance can be optimized by adjusting the threshold value VL for the individual color components, a liquid crystal display apparatus with high-speed and high-quality resolution can be realized.

FIG. 30 shows a circuit configuration showing yet another embodiment of the pixel circuit 100 in the present invention.

In the pixel circuit 100 shown in FIG. 30, the OR gate 760 is used as the logic device in stead of the transistor 740 shown in FIG. 22, in which the OR gate 760 is placed at the gate side of the transistor 30, one of the input terminal to the OR gate 760 is connected to the source of the transistor 710, the other input terminal to the OR gate 760 is connected to the timing line TMG, and its output terminal is connected to the gate of the transistor 730.

In this embodiment, as the OR gate 760 is turned "ON" when the signal level of either the voltage Vdata or the timing signal VTMG becomes "H", the same effect as shown in FIG. 22 using the pixel circuit 100 can be obtained.

In this embodiment, the transistor 730 is only a transistor connected to the display electrode 750. With this circuit configuration, the leak current and the noise can be more reduced in comparison with the circuit configuration including a pair of transistors connected to the display electrode 750 and hence, this circuit configuration contributes to the establishment of higher quality of display images so far.

In the individual embodiments of the present invention described above, the center voltage VCNT is used as the voltage applied to the reference line CNT. As for the voltage applied to the reference line CNT, the average voltage equivalent to the average value of the AC voltage VCP or zero value bias voltage can be used.

In case of displaying still images in the individual embodiments of the present invention, the device consumption power can be reduced by extending the period for initialization.

In the individual embodiments, as the voltage for the liquid crystal drive voltage VLC can be controlled independently with respect to the threshold voltage VL and the saturation voltage VH, respectively, good color balance conditions can be established in case of displaying color images. That is, by varying the amplitude value of the voltage VCP, both of the voltage corresponding to the saturation voltage VH and the voltage corresponding to the threshold voltage VL can be adjusted. On the other hand, by changing the pulse width of the timing signal VTMG, only the voltage corresponding to the threshold voltage VL can be adjusted. Therefore, the drive voltage can be adjusted for the saturation voltage by changing the amplitude value of the voltage VCP when Vdata is "H", and the drive voltage can be adjusted for the threshold voltage by changing the pulse width of the timing VTMG.

As described above, according to the present invention, as the electric charge stored in the liquid crystal may be initialized periodically, when the liquid crystal driving voltage changes in responsive to the image data, its change rate may be raised higher, and the animated images and the still images can be displayed in good conditions.

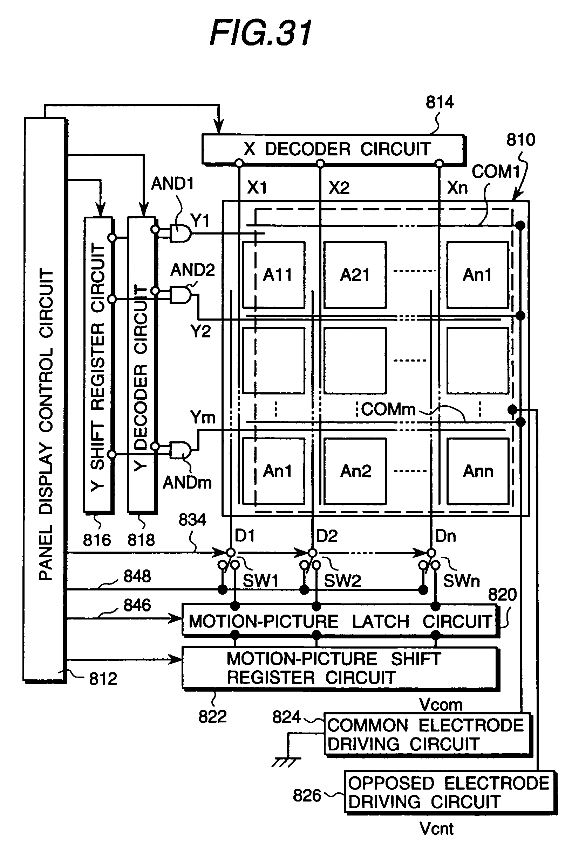

In Fig.31, the liquid crystal display apparatus is provided with a color panel 810 with 640 x 480 dots as a TFT active matrix type liquid crystal display. While in this embodiment only a color panel 810 and its periphery circuit are shown, the concrete configuration such as an optical system is abbreviated. the color panel 810 has a pair of substrates (not shown) of which at least one is transparent. The substrates is arranged so as to oppose to each other through a layer of the liquid crystal (not shown). A plurality of scanning electrode wires (Y-direction electrode wires) Y1 to Yn and a plurality of signal electrode wires (X-direction electrode wires) X1 to Xn intersecting in matrix with the scanning electrode wires are spread out over a surface of the substrate. Further, a plurality of display areas A11 to Ann surrounded by 480 scanning electrode wires Y1 to Yn and 640 signal electrode wires X1 to Xn are formed on a front surface of the color panel 810. display electrodes, opposed electrodes, switching devices for static pictures, switching devices for motion pictures, a control circuit for the static pictures and a control circuit for the motion pictures are provided on each of the display areas, and in the neighborhood of each of the display areas, the common electrode wires COM1 to COMn are formed in parallel with the scanning electrode wires, and the picture data electrode wires D1 to Dn is formed in parallel with the signal electrode wires. the electrode wires are insulated from and connected to one another.

The color panel 810 is provided with a panel display control circuit 812, an X decoder circuit 814, a Y register circuit 816, a Y decoder circuit 818, data selecting switches SW1 - SWn, a motion picture latch circuit 820, a motion picture shift register circuit 822, a common electrode driving circuit 824, and an opposed electrode driving circuit 826. the common electrode driving circuit 824 is connected to the common electrode wires COM1 to COMn, and the opposed electrode driving circuit 826 is connected to the opposed electrode in each display area.

The panel display control circuit 812 includes a control means for controlling the whole peripheral circuits based on a display command, and a motion picture display area designating means for designating a specified display area within the display area as a motion picture display area. The X decoder circuit 814 produces liquid crystal driving signals for static and motion pictures based on the panel display control circuit 812. The X decoder circuit includes a liquid crystal driving signal output means for static picture to output a liquid crystal driving signal for static picture to each of signal electrode wires X1 to Xn in synchronization with scanning pulses applied to the scanning electrode wires when the static picture is displayed, and a liquid crystal driving signal output means for motion picture to output a liquid crystal driving signal for motion picture to a designated signal electrode wire Xi in synchronization with scanning pulses applied to the scanning electrode wires when the motion picture is displayed.

Y shift register circuit 816 includes a Y decoder circuit 818, 2-input AND logic circuits AND1 to ANDn for pixel selection, and a scanning pulse output means for static pictures to output serially the scanning pulses to the disignated scanning electrode wire based on the signal from the panel display control circuit 812.

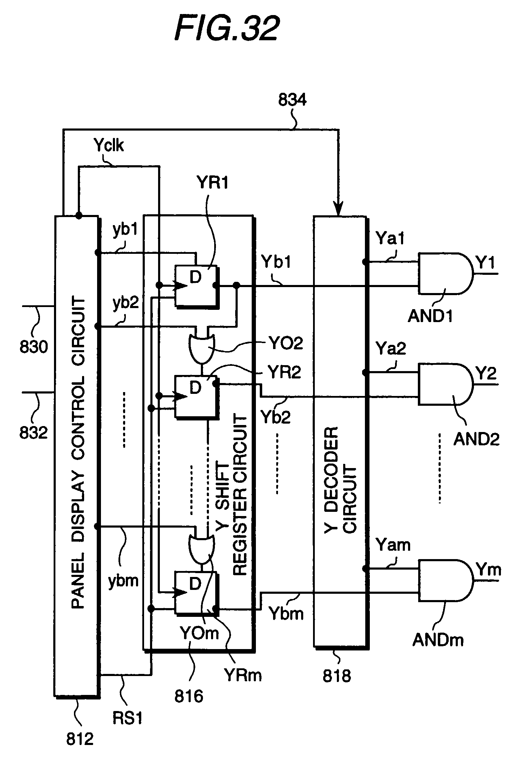

More concretely, the Y shift register circuit 816 comprises shift register circuits YR1 to Yrm, and 2-input OR circuits YO2 to YOm as shown in Fig.32. the Y shift register circuit 816 is connected to a panel display control circuit 12 through a clock electrode wire Yclk, start pulse electrode wires ycl to ycm and a reset electrode wire RS1, and the logic circuits AND1 to ANDm through output electrode wires Yb1 to Ybm. The panel display circuit 812 outputs 480 clock pulses to the clock electrode wire Yclk every one frame, and selects the start pulse electrode wire corresponding to a start position of the scan based on a signal input to a scanning start number electrode wire 830. Further, the circuit 812 outputs the start pulse to the selected start pulse electrode wire, and outputs a reset signal to the reset electrode wire RS1 when the shift register circuit is set, corresponding to the number designated by a signal input to the scanning number electrode wire 32. Namely, the Y shift register circuit 816 sets the start pulse from the start pulse electrode wire yci designated by the panel display control circuit 812 in synchronization with clock pulses, and outputs the set pulses to an OR circuit Yoi via an output electrode wire Ybi as the scanning pulse. The scanning pulses corresponding to the designated scanning number is sequentially output to the output electrode wire Ybi. The Y decoder circuit 818 is connected to the panel display control circuit 812 through the address electrode wire 834, and outputs the Y address data to the address signal wires Ya1 to Yam in response to the address signal from the panel display control circuit 812. The logic circuits AND1 to ANDm output the scanning pulse according to the logic product of the scanning pulse from the Y shift register circuit 816 and the Y address data from the Y decoder circuit 818, to the scanning electrode wires Y1 to Ym. In this case, if the whole scanning wire is designated, the scanning pulse is applied to the whole scanning wire, and if the specified scanning electrode wire is designated due to signals from the scanning start electrode wire 830 and the scanning number electrode wire 832, the scanning pulse is applied only to the designated scanning electrode wire.

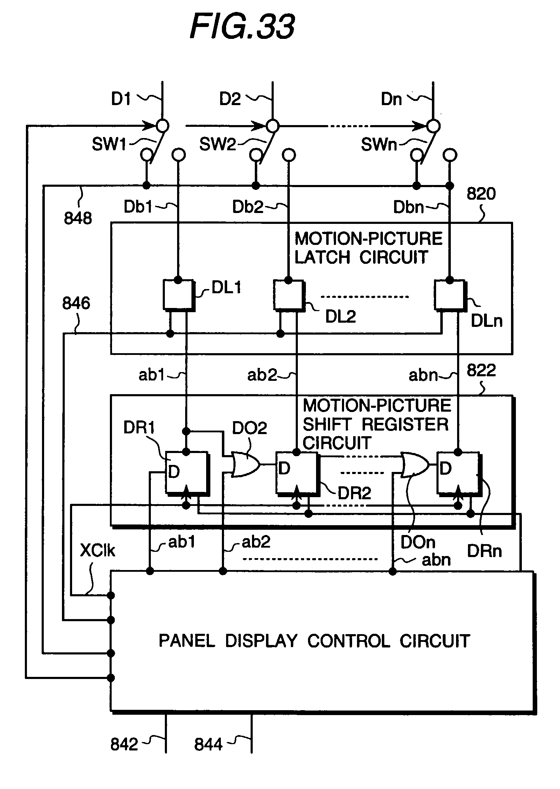

Fig.33 shows the configuration of a motion picture signal circuit. each of a motion picture latch circuit 820 and a motion picture shift register circuit 822 is configured as a motion picture data output means for outputting the motion picture data only to the designated display area, based on a signal from the panel display control circuit 812. Concretely, as shown in Fig.33, the motion picture latch circuit 820 includes 640 latch circuits DL1 to DIn, and the motion picture shift register 822 includes shift register circuits DR1 to DRn and 2-input OR circuits DO2 to DOn. Further, the motion picture shift register 822 is connected to the panel display control circuit 812 through the clock electrode wire Xclk, the start pulse electrode wire da1 to dan and the reset electrode wire RS2. The panel display control circuit 812 outputs sequentially the clock pulses to the clock electrode wire Xclk. The clock pulses are output sequentially at the same timing as the sequential output of 640 motion picture data when the scanning pulse is applied to the scanning electrode wire.

Furthermore, the panel display control circuit 812 outputs the start pulse to the start pulse electrode wire corresponding to the scanning start number designated by a signal from the scanning start number electrode wire 842, and outputs the reset pulse to the reset electrode wire RS2 when the shift register circuits of the number designated by an input signal of the scanning number electrode wire 844. Namely, the motion picture shift register circuit 822 outputs the start pulse to the OR circuit DOi in the next stage as the scanning pulse, the start pulse being input to the start pulse electrode wire corresponding to the scanning start number out of the start pulse electrode wire da1 to dan. Therefore, only the scanning pulse from the shift register circuit DRi corresponding to the designated motion picture area is output from the motion picture shift register circuit 822. The motion picture latch circuit 820 connected to the panel display control circuit 812 through the motion picture analog signal wire 846, latches the motion picture data input from the motion picture analog signal wire 846 in response to the pulse from the output electrode wire dbi, and outputs the latched motion picture data the motion picture electrode wires Db1 to Dbn. Namely, the motion picture data from the motion picture latch circuit 820 is output to the motion picture electrode wire corresponding to the motion picture display area out of the motion picture electrode wire Dbi to Dbn. And then, the motion picture data is output to the picture data electrode wires D1 to Dn through the data selecting switches SW1 to SWn.

The data selecting switches SW1 to SWn operates as the picture data selecting circuit. The data selecting switches select the static picture data when the static picture is displayed and the motion picture when the motion picture is displayed, and outputs any of the selected picture data to the picture data electrode wires D1 to Dn.

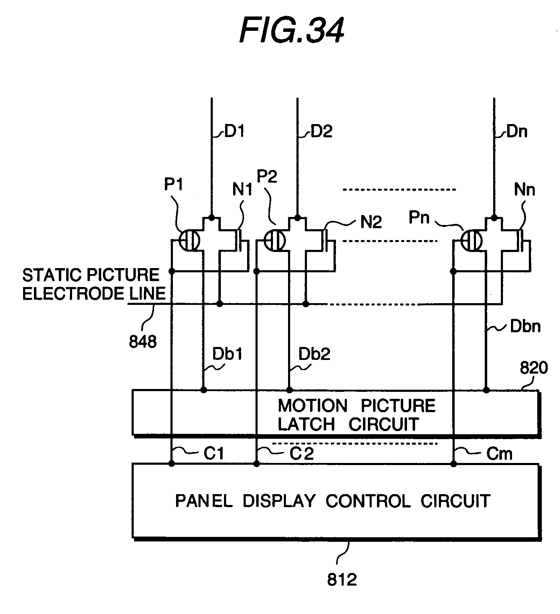

More concretely, as shown in Fig.34, each data selecting switches SW1 to SWn is provided with p-type TFTS or transistors P1 to Pn and n-type TFTs or transistors N1 to Nn. The gate of each of the transistors is connected to the panelcontrol circuit 812 through the selecting signal electrode wires C1 to Cm, an d the source thereof is connected to the picture data electrode wires D1 to Dn. Further, the drain of each of the transistors P1 to Pn is connected to the motion picture latch circuit 820 and the drain of each of the transistors N1 to Nn is connected to the static picture electrode wire 848. The transistors N1 to Nn turn to "ON" when the level of the selecting signal electrode wire Ci becomes "H" during the display of the static picture, and output the static picture data from the static picture electrode wire 848 to the picture data electrode wire D1 to Dn. While, the transistors P1 to Pn turn to "ON" when the level of the selecting signal electrode wire Ci becomes "L" during the display of the motion picture, and output the motion picture data from the motion picture latch circuit 820 to the picture data electrode wire D1 to Dn.

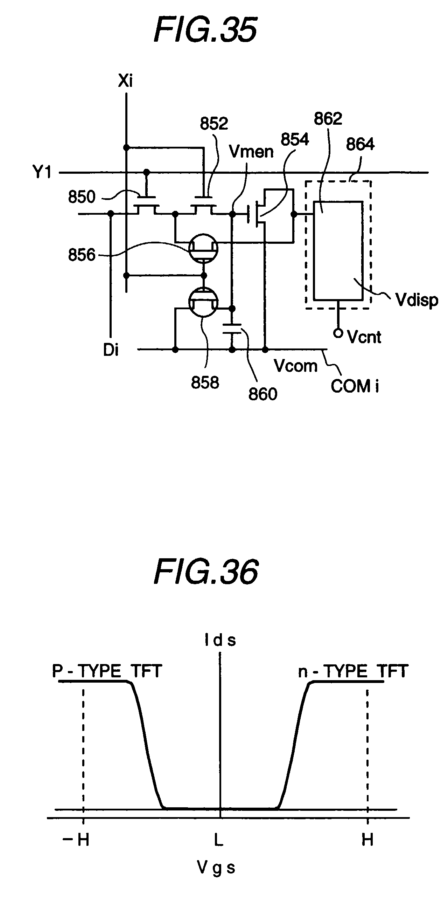

While, as shown in Fig.35, n-type TFTs or transistors 850, 852, 854, p-type TFTs or transistor 856,858, a capacitor 860 for holding the display data, a display electrode 862, and an opposed electrode 864 are provided in each of display areas A11 to Ann. The display electrode 862 or transparent electrode is arranged to face to the opposed electrode 864 through a liquid crystal layer sandwiched between them. The alternating voltage Vcnt is applied to the opposed electrode 864. The display electrode 862 is connected to the transistor 854. The transistor 854 or switching device for the static picture has a source connected to the display electrode 862, a drain connected to the common electrode wire COMi and the gate connected to the source of the transistor 852 and the common electrode wire COMi through a capacitor 860. The transistor 852 is connected in series with the transistor 850. A gate of the transistor 852 is connected to the signal electrode wire Xi and its drain is connected to the source of the transistor 850 and the drain of the transistor 856. A gate of the transistor 850 is connected to the scanning electrode wire Yi and its drain is connected to picture data electrode wire Di. The transistor 850, 852, and capacitor 860 forms a control circuit for the static picture to control the ON state of the transistor 854.

While, the transistor 856 operates as the switching device for the motion picture. the source of the transistor 856 is connected to the display electrode 862, its drain is connected to the source of the transistor 850 and its gate is connected to the gates of the signal electrode wire Xi and a transistor 858. A drain of the transistor 858 is connected to the gate of the transistor 854, and its source is connected to the common electrode wire COMi. As seen from Fig.36, the transistors 850 to 854 each turns to a "ON" state only when the level of the voltage applied to the gate is at "H". Similarly, the transistors 856 to 858 each turns to a "ON" state only when the level of the voltage applied to the gate is at "-H". Otherwise, a "OFF" state. The transistor 858 constructs scanning electrode for the motion picture, along with transistors 850,852.

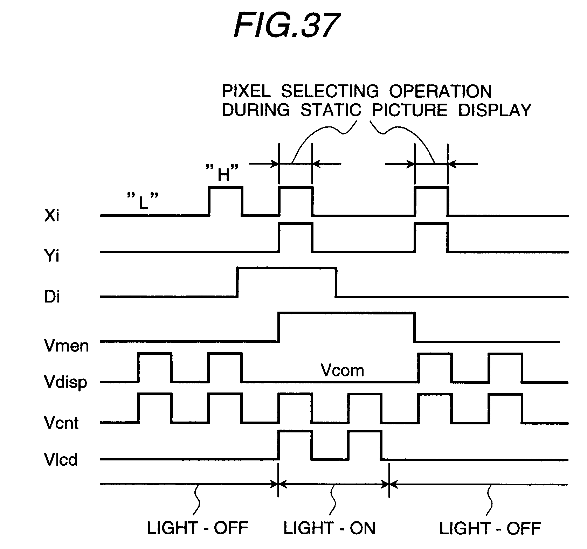

An operation state in which the static picture is display in each of display regions will be explained on the basis of the timing chart shown in Fig.37. In Fig.37, Vdisp designates an electric potential of the display electrode 862, and Vlcd designates a voltage applied to the liquid crystal sandwiched between the display electrode 862 and the opposed electrode.

In Fig.37, when the static picture is displayed, the static picture data is selected by using the data selecting switches SWi. If both levels of the signal electrode wire i and the scanning electrode wire Yi becomes "H" when the electric potential of the picture data electrode wire Di is at "H", both transistors 850, 852 turn to "ON". As a result, the transistor 854 turns to "ON" according to the static picture data from the picture data electrode wire Di. At this time, the gate potential Vmem of the transistor 854 turns to "H", and the static picture data is charged to the capacitor 860. Further, according to the state of "ON" of the transistor 854, the electric potential Vdisp of the display electrode 862 becomes the same potential as the potential Vcom of the common electrode wire. Because an alternating voltage Vcnt is applied to the opposed electrode 864, the difference voltage Vlcd between the voltages Vdisp and Vcnt is applied to the liquid crystal, and thus the liquid crystal may light on. If the liquid crystal (pixel) is lighted on due to such a pixel selecting operation, the liquid crystal once lighted on keeps lighting for a long time because the picture data is held for a long time by the capacitor 860. The holding time depends upon a leakage current of the transistor 854 and the capacity of the capacitor 860. Normally, the leakage current of a transistor is very small. Accordingly, the holding time is far longer than the typical frame time of 16.7 ms.

Since the liquid crystal once lighted on keeps holding the light-on state for a predetermined time, it is, therefore, not necessary to apply a voltage due to the same picture data every one frame (16.7 ms) when it is not required to change a state of the liquid crystal. Accordingly, because it is not necessary to charge and discharge the capacity formed by the wires and the liquid crystal faced to the opposed electrode and the capacity formed at the wire intersecting portion of electrode wires every frame, the power consumption can be reduced.

On the other hand, when the level of the picture data turn to "L" under the "ON" state of the transistors 850, 852 during the pixel selecting operation, the gain Vmem at the gate of the transistor 854 turn to "L", the electric charges being charged in the capacity 860 discharge, and thus the transistor 854 turns to an "OFF" state. Because the voltage Vdisp becomes the same potential as Vcnt at this time, the voltage applied to the liquid crystal becomes interrupted, and thus the liquid crystal makes a state of "LIGHT-OFF".

As described above, when both the signal electrode wire Xi and the scanning electrode wire Yi become "H" during the display of the static picture, and the pixel selecting operation is carried out, the liquid crystal is lighted on when the static picture data "H" is input to the picture data electrode wire Di, and the liquid crystal is lighted off when the data "L" is input to it. Because in this case, the liquid crystal once lighted on (displayed) keeps lighting on, it is not necessary to perform periodically the pixel selecting operation to display the static picture. Accordingly, such an operation is performed only when a new static picture is written in. Accordingly, because it is not necessary to charge and discharge the capacity formed by the wires and the liquid crystal faced to the opposed electrode and the capacity formed at the wire intersecting portion every frame when the static picture is displayed, the power consumption can be reduced.

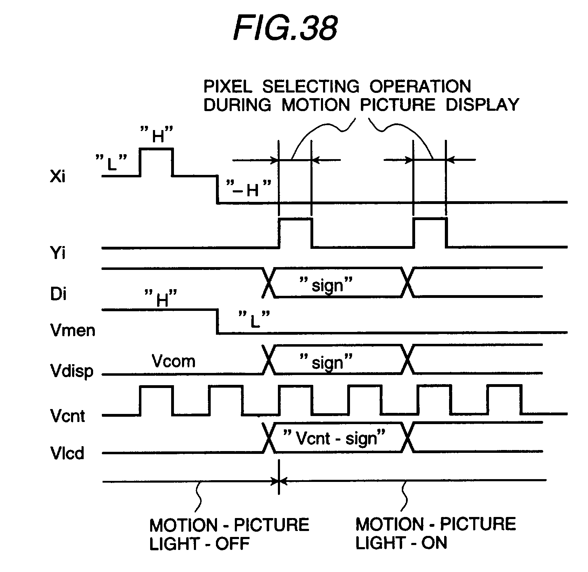

An operation state in which the motion picture is display in each of display regions will be explained on the basis of the timing chart shown in Fig.38. If "sig n" is input to the picture data electrode wire Di as a motion picture data due to the selecting operation of the data selecting switch SWi, when the level of the voltage of the signal electrode wire Xi becomes "-H" and the level of the voltage of the scanning electrode wire Yi becomes "H", the transistors 850, 856, 858 turn to "ON", the motion picture data is applied to the display electrode 862. At this time, the transistor 852 is at an "OFF" state. Therefore, the Vmem turns to "L", and the transistor 854 turns to "ON".

The picture data such as static pictures being charging in the capacitor 860 is discharged when the transistor 858 turns to "ON". The voltage Vlcd applied to the liquid crystal is the difference voltage Vcnt - Vdisp between the voltages Vcnt and Vdisp. The liquid crystal is lighted on based on the difference voltage, namely, the motion picture is displayed. It should be noted that the optimum motion picture can be displayed without flickers by setting the time interval of the selection of motion pictures to 1/60 second.

The static picture and the motion picture can be displayed, respectively, at a static and a motion picture region at the same time, by separating the display region.

When the static picture is displayed at the static picture region, an output of the Y shift register circuit 816 is at an "H" state, and address signals input from the panel display control circuit are sequentially output from a Y decoder circuit 818. Thus, Y address data based on the address signals are output from the logic circuit ANDi. X address data based on the address signals input from the panel display control circuit 812 are output from a Y decoder circuit 814. The data selecting switch Swi selects a static picture data from a static picture electrode wire 834, and output the selected static picture data to the picture data electrode wire Di. Thus, the X address data is applied to the signal electrode wire Xi in the static picture region, the Y address data is applied to the scanning electrode wire Yi, and the static picture data is applied to the picture data electrode wire Di in synchronization with the Y address data and the X address data.

When the motion picture is displayed at the motion picture region, a scanning pulse is output from the output electrode wires (corresponding to the motion picture display region) designated by the Y shift register circuit 816, and a signal indicative of the "H" state output from the address signal wires (corresponding to the motion picture display regions) designated by the Y decoder circuit 818. Further, a scanning pulse is output to the scanning electrode wires (corresponding to the motion picture display region) designated by the logic circuit ANDi. While, a signal indicative of the "-H" state is output from the X decoder circuit 814 to the signal electrode wires (corresponding to the motion picture display region). The data selecting switch SWi selects the motion picture data from the designated motion picture electrode wires (corresponding to the motion picture display region) of the motion picture latch circuit 820, and outputs the selected motion picture data to the picture data electrode wire Di. A signal indicative of the "-H" state is applied to each electrode wires Xi corresponding to the motion picture display region, a scanning pulse is applied to the scanning electrode wire Yi, and the motion picture data is applied to the picture data electrode wire Di in synchronization with the scanning pulse.

The following Table 1 shows the above relationship.

Table 1

|  | Static picture region | Motion picture region |
| --- | --- | --- |
| Y shift register | H | Scan pulse |
| Y decoder | Y address data | H |
| 2 input AND circuit for pixel selection | Y address data | Scan pulse |
| X decoder | X address data | -H |
| Data selecting switch | Static picture data | Motion picture data |
| Scanning electrode wire | Y address data | Scan pulse |
| Signal electrode wire | X address data | -H |
| Display electrode | Static picture data | Motion picture data |

Further, in case that the light-on, the light-off and the storage operation with respect to the picture data are performed in the static picture region, or in case that the light-on and the storage operation with respect to the picture data are performed in the motion picture region, the relationship among the electric potentials of the electrode wires is represented in the following Table 2.

Table 2s

|  | Scanning electrode wire | Signal electrode wire | Picture data electrode wire | Display electrode wire |
| --- | --- | --- | --- | --- |
| Static Light-on picture Light-off region Storage | H | H | H | Vcom |
|  | H | H | L | Vcnt |
|  | L | - | - | Vcom>Vcom |
|  | - | L | - | Vcnt>Vcnt |
|  | L | -H | - |  |
| Motion Light-on picture Storage region | H | -H | sign | sign |
|  | L | -H | sign +1 |  |
|  | L | - | - | sign>sign |
|  | - | L | - |  |

In case that the static picture is displayed (lighted on) in the static picture region, by applying "H" to each of the scanning electrode wire Yi, the signal electrode wire Xi and the picture data electrode wire Di, the electric potential of the display electrode 862 becomes equal to the electric potential Vcom of the common electrode wire, and the liquid crystal is lighted on. While, the lighted static picture is erased by applying "H" to the scanning electrode wire Yi and "H" to the signal electrode wire Xi, applying the data of "L" to the picture data electrode wire Di, and allowing the electric potential of the display electrode 862 to be equal to Vcnt. The once lighted static picture can be kept by allowing either one of the scanning electrode wire Yi and the signal electrode wire Xi. Even if the signal "L" or "H" is applied to the picture data electrode wire Di at this time, the state of the display electrode 862 does not change. Similarly, even if the signal "-H" is applied to the signal electrode wire Xi, it does not change.

In case that the motion picture is displayed (lighted on) in the motion picture region, "H", "-H" and "sig n" are applied to the scanning electrode wire Yi, the signal electrode wire Xi and picture data electrode wire Di, respectively. Thereby, the motion picture data "sig n" is applied to the display electrode 862, the liquid crystal is lighted on and the motion picture is displayed. If either one of the signal level of the scanning electrode wire Yi or that of the signal electrode wire Xi is at the "L" level, the displayed motion picture is held. At this time, even if any signals are applied to the picture data electrode wire Di, the state of the display electrode 62 is constant.

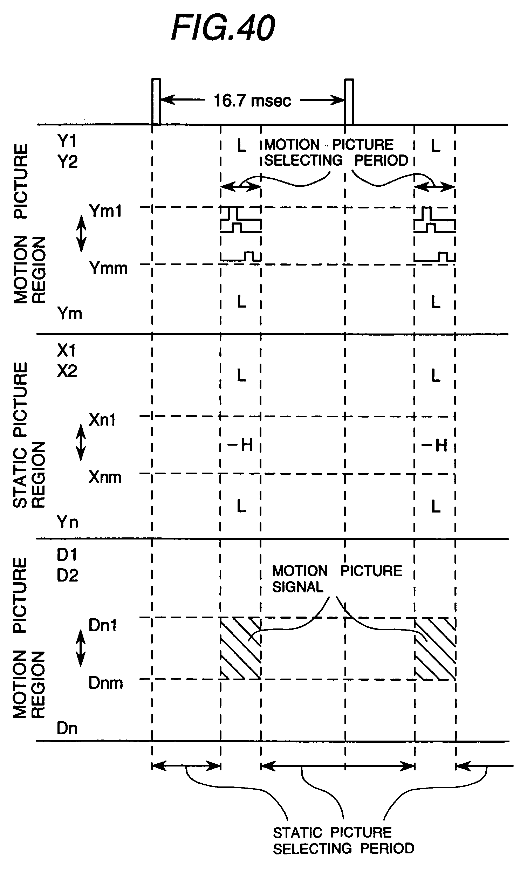

The display of the motion picture and the static picture to the mixed region of the motion picture and the static picture display regions will be explained next, with reference to Fig.40. Fig.40 is a timing chart illustrating the operation of displaying the static picture and the motion picture at the same time. Where, the time of one frame is sixtieth seconds or 16.7 ms. Ym1 to Ymm, one of the electrode wire corresponding to the motion picture display region designate the scanning electrode wires, Xn1 to Xnn the signal electrode wires, and Dn1 to Dnn the picture data electrode wires. Each of static picture and the motion picture display regions is set in accordance with the command from a panel display control circuit 812. Further, the time for selecting the static picture and the time for displaying the static picture are separated and driven, from the time for selecting the motion picture and the time for displaying the motion picture, respectively.

When the processing to display the display of one frame is started, the command to display the static picture is output from the panel display control circuit 812, and the data or the signal shown in table 1 is applied sequentially to the scanning electrode wire Yi, the signal electrode wire Xi and the picture data electrode wire Di which belong to the static picture display region. Accordingly, the light-on and light-off and the holding or storage of the liquid crystal which belongs to the static picture display region is performed based on the static picture data. Namely, the liquid crystal in the static picture display region is lighted on and lighted off, and held. As a result, the static picture is displayed based on the picture data.

When it becomes the time the motion picture is displayed on the motion picture display region, in the course of the carryout of the selecting scan to the scanning electrode, the motion picture data or the signal shown in Tables 1 and 2 is applied sequentially to the scanning electrode wire Yi, the signal electrode wire Xi and the picture data electrode wire Di which belong to the motion picture display region. Accordingly, the motion picture is display sequentially on the motion picture display region. The motion picture display time exists one time every one frame, and the processing of the motion picture which belongs to the time is repeated every frame.

In case that the static picture is displayed , the selecting operation is not performed until it becomes necessary to rewrite with regard to the liquid crystal which belongs to the display region displayed once. Namely, the state of the write-in is maintained until it becomes necessary to rewrite.

As described above, even if the static picture and the motion picture is mixed and displayed at the same time, the pixel selecting operation is not performed with respect to the static picture displayed once until it becomes necessary to rewrite. Accordingly, because it is not necessary to charge and discharge the capacity formed by the liquid crystal between wires and an opposed electrode 864, and the capacity formed at the intersecting portion of wires and that formed every one frame, it can reduce the power consumption.

Further, even if the motion picture is displayed, it is not necessary to display the motion picture on the whole display region but a specified display region. Accordingly, it can reduce the power consumption. Further, because the motion picture data is applied sequentially to the signal electrode wire Xi which belong to the motion picture display region, out of the signal electrode wire intersecting to the selected scanning electrode wire Yi within the period of time one scanning electrode wire Yi is selected.

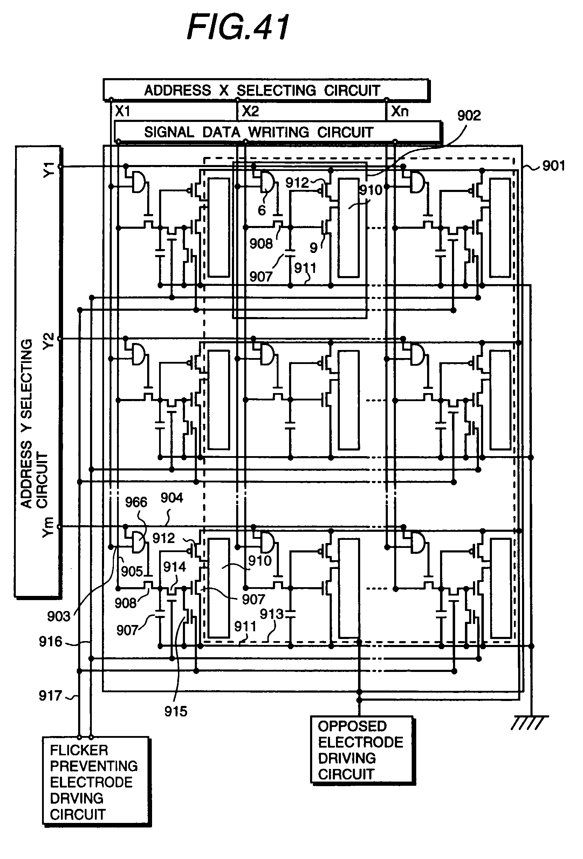

Fig.41 is a schematic view of the liquid crystal display apparatus according to a fourth embodiment of the present invention. Pixel portions 902 each formed from m high by n wide matrix of dots are arranged in matrix on a display portion 901 formed on a TFT substrate (not shown). An address X electrode 903, an address Y electrode 904 and a signal electrode 905 are connected to each of the pixels. Each pixel includes an AND circuit 906 for recognizing the designated address, a display data holding circuit having a sampling capacitor 907 and a sampling TFT 908, a pixel driving TFT 909 and a display electrode 910. The address X electrode 903 is connected to an address X selecting circuit, the address Y electrode 904 to an address Y selecting circuit, and the signal electrode 905 to a signal data writing circuit. A common electrode 911 is grounded. A display-off TFT 912 for lighting off the liquid crystal provides the voltage of the opposed electrode to the display electrode 910 based on an electric potential of the sampling capacitor 907. A opposed electrode 909 formed on an counter substrate faces through a liquid crystal to the transparent electrode provided on the TFT substrate. The opposed electrode 909 is driven by a opposed electrode driving circuit. The liquid crystal display apparatus has a polarizer and a back light (not shown) in addition to the above configuration.

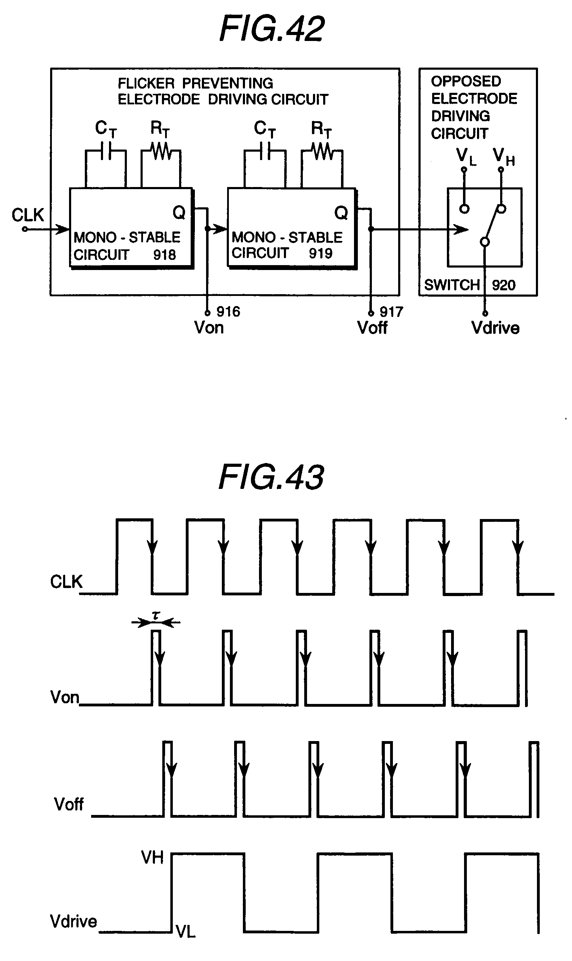

In order to prevent the flicker, a TFT switch 914 and a TFT switch 915 are provided in pixels 902 every other rows. A gate of each of the TFT switches is connected to the flicker preventing electrodes 916 and 917. The two electrodes 916 and 917 is connected to a driving circuit for the flicker preventing electrodes. The flicker preventing electrode driving circuit is a timing pulse generating circuit for driving the TFT switch 914 and the flicker preventing OFF switch 915. An embodiment of the flicker preventing electrode driving circuit is shown in Fig.42, and a timing chart of the pulses shown in Fig.42 is shown in Fig.43. A mono-stable circuit or mono-stable multi-vibrator generates a pulse-like signal with a constant time width $\tau$, in synchronization with the fall of the pulse-like signal. After outputting the pulse-like signal with a constant time width, the circuit returns an initial state. The constantly stable point is one. The time width $\tau$ is determined by the value of a capacity CT and a resistor RT for timing provided outside. If a clock CLK as shown in Fig.43 is input to the mono-stable circuit 918, the fall of the output Q becomes a pulse-like signal with a constant time width $\tau$ like Von. The output is input to exactly the same mono-stable circuit 919. An output of the circuit 919 is a pulse-like signal with a constant width $\tau$ like Voff at the fall of Von. A switch 920 is operated like a toggle switch by the output signal of the circuit 919. As a result, a square wave, Vdrive with two values VL and VH is obtained, the opposed electrode is driven.

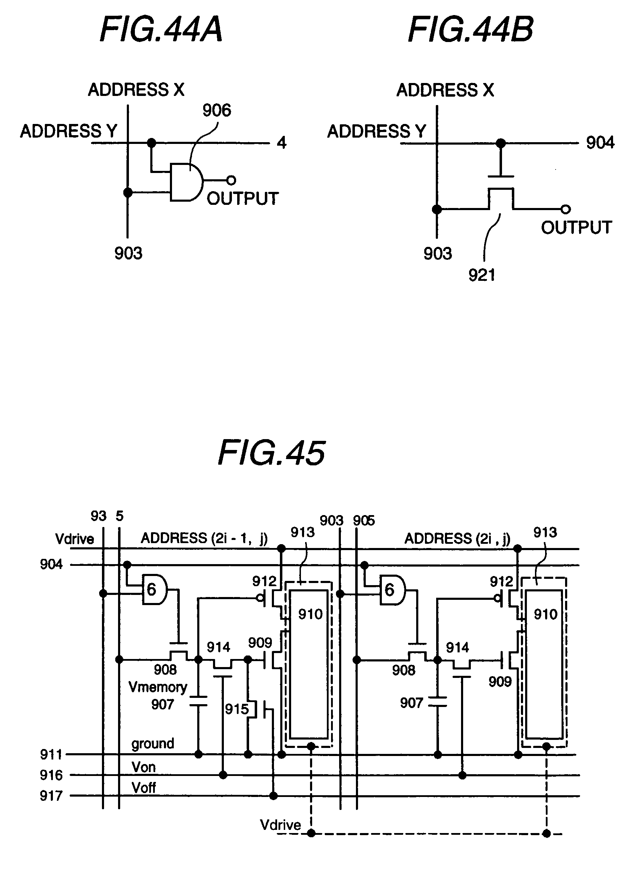

Figs.44B show an example of the AND circuit 906 shown in Fig.44A. The address Y electrode 904 is connected to a gate of an AND TFT 921, and the address X electrode is connected to its source. If the address Y electrode becomes a high level, the AND TFT 921 turns to an "ON" state and the electric potential of the address X electrode is transmitted to the output.

Fig.45 shows in detail the address (2i-1,j)and the next address (2i,j) of the pixel shown in Fig.41. Where, i and j are integers which satisfy $1 \leq i \leq n/2$ and $1 \leq j \leq m$, respectively.

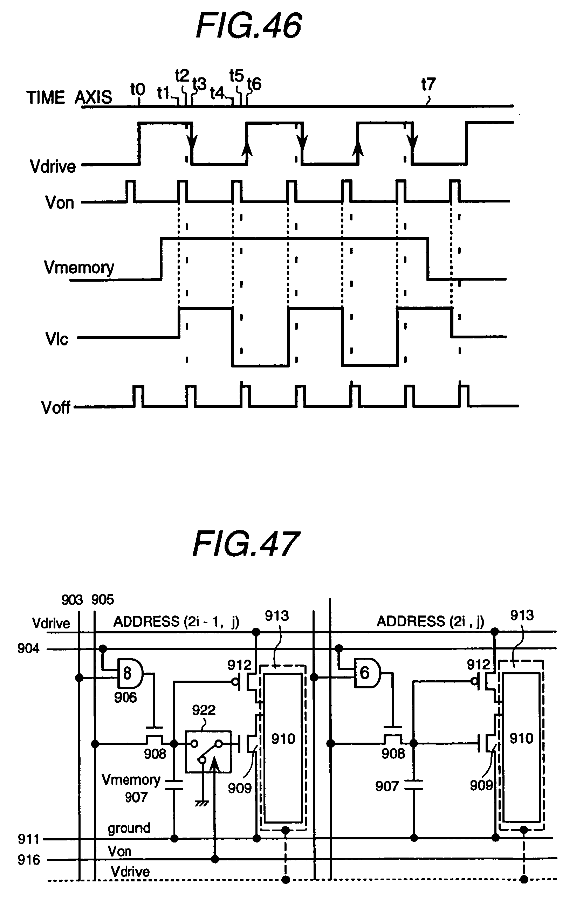

Fig.46 is a wave form chart illustrating the operation of a liquid crystal display device with the pixel circuit shown in Fig.45. Vdrive is a square-wave-like liquid crystal driving voltage applied to the opposed electrode 913. Von is a timing pulse applied to a flicker preventing electrode 916 from the flicker preventing electrode driving circuit, for turning a TFT switch 914 on. Voff is a timing pulse applied to a flicker preventing electrode 917 from the flicker preventing electrode driving circuit, for turning a TFT switch 915 on. The Von is output just before the rise and the fall of the square pulse of Vdrive, and Voff is output just after Von. The pulse time width of Von is the time required to turn the pixel driving TFT 909 on, and that of Voff is the time required to turn the TFT switch 915 on and turn the pixel driving TFT 909 off. Vmemory is the voltage of the sampling capacitor 907 at the address (2i,j). Vlc is the voltage applied to the liquid crystal at the address (2i,j). It should be noted that the liquid crystal driving voltage means the voltage generated in the opposed electrode driving circuit, and the liquid crystal applying voltage means the voltage applied to the liquid crystal sandwiched between the display electrode 910 and the opposed electrode 913, whose magnitude is corresponding to the difference of the electric potential between the electrodes 910 and 913.

The principle of operation will be explained with reference to Figs.45 and 46. If Vmemory is at a low level before t0, the pixel driving TFT 909 never turn on even if the TFT switches 914 and 915 are in any states. When the display-off TFT 912 is in an "ON" state, Vdrive is applied to the display electrode 910. The electric potential of the display electrode 910 is equal to that of the opposed electrode 913, and a voltage is not applied to the liquid crystal. If Vmemory changes its state to a high level at the time t0, the display-off TFT 912 is cut off. Because the display electrode 910 is not electrically connected to anywhere, and does not have the storage of the electric charges, the electric potential of the display electrode 910 is equal to that of the opposed electrode 913, and thus a voltage is not applied yet to the liquid crystal. If the timing pulse of Von is input at the time t1, the TFT switch 14 is turned on. Because at this time, the TFT switch 915 is in the "OFF" state and the display-off TFT 912 is also in the "OFF" state, the pixel driving TFT 901 is controlled by the voltage of Vmemory and turned to "ON". Thereby, the display electrode 910 is connected to the common electrode 911, and an electric potential is generated between the display electrode 910 and the opposed electrode 913. Therefore , Vdrive is applied to the liquid crystal applying voltage Vlc. If Von turns to an "OFF" level again, the TFT switch 914 turns off. However, because the electric charges are stored in the gate of the pixel driving TFT 909, the pixel driving TFT 909 is maintained to be in an "ON" state. Accordingly, Vdrive is still applied to Vlc. Next, the timing pulse Voff is input at the time t2 and the TFT switch 915 is turned on. Thereby, the gate of the pixel driving TFT 909 is grounded and turned off. Because the electric charges of the display electrode 910 is still stored, the electric potential between the display electrode 910 and the opposed electrode 913 is not changed and Vlc is not changed. Further, because the electric charges of the display electrode 910 is stored even if the polarity of Vdrive is changed at the time t3, Vlc is not changed. In order to invert the polarity of Vlc, the TFT switch 914 is turned on at the time t4 just before the rise t6 of Vdrive and thereby turning the TFT 909 on. As a result, the voltage of Vdrive is applied to Vlc. The voltage of Vlc is maintained by turning the TFT switch 915 on at the time t5 and turning the pixel driving TFT 909 off. By carrying out periodically such switching, the inversion of the polarity is repeated and thus Vlc is alternated. As compared the phase of Vlc with that of Vdrive when the switching has carried out at the above timing, Vlc lags approximately 180° in phase with respect to Vdrive as seen from Fig.46. It is because the edge of the rise of the liquid crystal applying voltage at the pixel including the switch appears just before the edge of the fall of the liquid crystal driving voltage and thus there is the phase difference of a half period , when one periodic cycle or 360° is from the edge of the rise of the liquid crystal to the next one. If Vmemory turns to a low level at t7, then the display-off TFT 912 is turned on and Vdrive is applied to the display electrode 910. The electric potential of the display electrode 910 becomes equal to that of the opposed electrode. As a result, a voltage is not applied to the liquid crystal and thus the liquid crystal is lighted off.

While, at the address (2i,j) of the pixel not including the flicker preventing switch, the liquid crystal applying voltage has the same phase as Vdrive. As described above, Vlc lag approximately 180° in phase with respect to Vdrive. Namely, the liquid crystal applying voltage of the pixel having the flicker preventing switch is inverted in phase with respect to one of the pixel not having the flicker preventing switch. Further, their pixels are adjacent to each other. There are three states, a first one is such a state that the polarity of the liquid crystal applying voltages are inverted to each other in the time between the adjacent pixels, a second one is such a state that the polarity of the voltages is the same as each other and positive, and a third one is such a state that the polarity of the voltage is the same as each other and negative. When the distance between the pixels is narrow, the viewing angle between the adjacent pixels becomes narrow. Therefore, in case that the polarity is inverted, it is difficult to identify the difference in gray levels between the adjacent pixels. In other words, the eyes of human being normally identifies the gray level through the average gray level of a positive gray level and a negative gray level. In this embodiment, three gray levels, that is, the average gray level, the gray level when the polarity is positive and the gray level when negative, are sequentially displayed. However, because the phase lag is approximate 180° , the percentage of the average gray level is large, and thus the flicker is prevented.

While the configuration for preventing flicker added to the pixel is provided every other columns, it is possible to provide the configuration every other rows or arrange the configuration like checker, because the pixel having the flicker preventing switch can be adjacent to the pixel not having the flicker preventing switch.

Another embodiment of the present invention will be explained next. It is also possible to prevent the flickers by using the configuration shown in Fig.47.

In the configuration shown in Fig.47, a flicker preventing switch 922 is utilized, instead of the TFT switches 914 and 915.

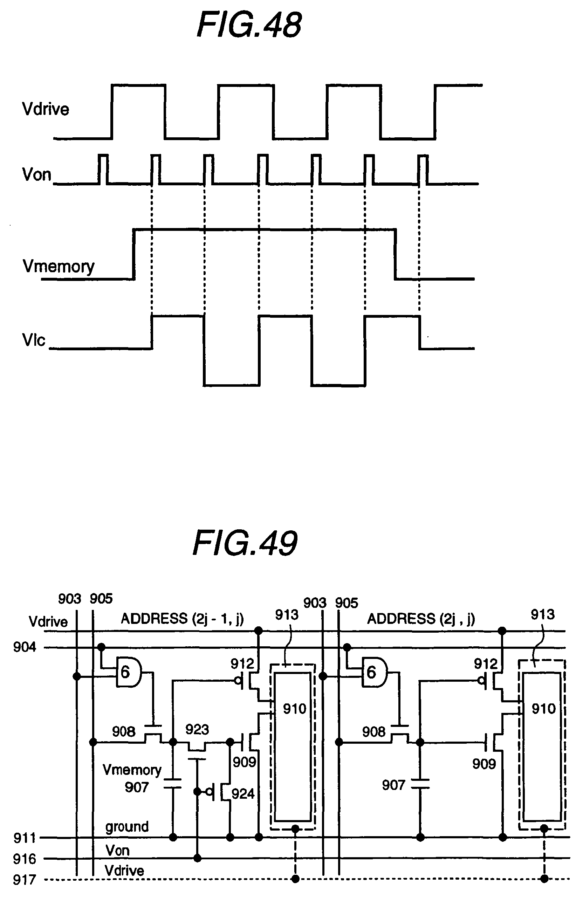

Fig.48 shows the switching operation of the flicker preventing switch 922. Vdrive is a square-wave-like alternating voltage applied to the opposed electrode 913. Von is a timing pulse by which the flicker preventing switch 922 switches from the ground level to the level of the sampling capacitor 907 at the address (2i-1,j). The Von is output just before the rise and the fall of the square pulse of Vdrive. Vmemory is the voltage of the sampling capacitor 907 at the address (2i,j). Vlc is the voltage applied to the liquid crystal at the address (2i,j).

The principle of operation will be explained. If Von is at a high level, the flicker preventing switch 922 is turned on. Thefore, the pixel driving TFT 909 is controlled by the voltage of Vmemory. At this time, Vdrive is applied to the liquid crystal at the address (2i-1,j) like Vlc.

If Von turns again to the "OFF" level, the flicker preventing switch 922 turns off and thus the pixel driving TFT 909 turns off. Even if the polarity of Vdrive is inverted, that of Vlc is not changed and thus its magnitude is constant. Vlc is alternated by turning the flicker preventing switch 922 on. As a result, the phase of Vlc has the difference by 180° out of the phase of Vdrive. Namely, the liquid crystal applying voltage of the pixel having the flicker preventing switch is inverted in phase with respect to one of the pixel not having the flicker preventing switch. Thereby the flicker can be prevented.

Another embodiment will be explained. Fig.49 shows the configuration of the pixel circuit with a p-channel TFT, in which an n-channel TFT 923 and a p-channel TFT 924 are utilized, instead of the TFT switches 914 and 915 shown in Fig.41 or 45. Gates of the TFTs are connected to the flicker preventing electrode 916, and a drain of the p-channel TFT 924 is grounded.

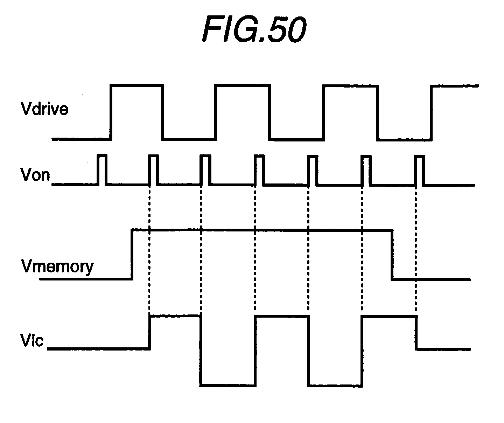

Fig.50 shows the switching operation of the flicker preventing switches. Vdrive is a square-wave-like alternating voltage applied to the opposed electrode 913. Von is a timing pulse applied to the flicker preventing electrode 916 from the flicker preventing electrode driving circuit. The Von is output just before the rise and the fall of the square pulse of Vdrive. Vmemory is the voltage of the sampling capacitor 907 at the address (2i-1,j). Vlc is the voltage applied to the liquid crystal at the address (2i-1,j).

The principle of operation will be explained. If the timing pulse of Von is input to the n-channel TFT 923 and the p-channel TFT 924, the n-channel TFT 923 is turned on and the p-channel TFT 924 is turned off. Therefore, the gate of the pixel driving TFT 909 is connected to the sampling capacitor 907, and controlled by the voltage of Vmemory. At this time, Vdrive is applied to the liquid crystal at the address (2i-1,j). If Von turns again to the "OFF" level, the n-channel TFT 923 turns off and the p-channel TFT turns on. Thus the pixel driving TFT 909 turns off. Because the electric charges are still stored in the display electrode, the polarity of Vlc is not changed even if the polarity of Vdrive is inverted. Vlc is alternated by carrying out periodically such switching operation. As a result, the phase of Vlc has the difference by 180° out of the phase of Vdrive.

While, at the address (2i,j) of the pixel not including the flicker preventing switch, the liquid crystal applying voltage has the same phase as Vdrive. As described above, Vlc lag approximately 180° in phase with respect to Vdrive. Namely, the liquid crystal applying voltage of the pixel having the flicker preventing switch is inverted in phase with respect to one of the pixel not having the flicker preventing switch. As a result, the flicker is prevented.

It should be noted that it must not set threshold voltages for the on-off operation of the n-channel and the p-channel TFTs so as to overlap to each other. In case that there is a value of the voltage at which both TFTs are turned off, the electric charges of the sampling capacitor 907 flow to the ground and thus the normal display data is missed. Further, by combining the n-channel TFT with the p-channel TFT, the reliable operation of the timing switch is insured.

## Claims

1. A liquid crystal display apparatus having a pair of substrates of which at least one substrate is transparent and a liquid crystal layer sandwiched between the substrates, comprising:

   a plurality of scanning electrodes (3) formed on one of the substrates;
   a plurality of signal electrodes (4) intersecting like a matrix with said plurality of scanning electrodes (3);
      wherein the display apparatus further comprises the followings within each of the regions surrounded by said plurality of scanning electrodes (3) and said plurality of signal electrodes (4);
   a display data holding circuit (5) connected to the corresponding scanning electrodes (3) and signal electrodes (4), for fetching and storing a display data from the signal electrode (4) in response to a scanning signal;
   a switching device connected to said display data holding circuit (5), its switching operation being controlled by the holding circuit;
   a display electrode (750) connected to said switching device.

2. A liquid crystal display apparatus according to claim 1, wherein an opposed electrode (770) which faces to said display electrode (750) is provided on the other substrate of said pair of substrates, and a common electrode (8) connected to a switching device within each of the regions is provided on one substrate thereof.

3. A liquid crystal display apparatus having a pair of substrates of which at least one substrate is transparent and a liquid crystal layer sandwiched between the substrates, comprising:

   a plurality of first scanning electrodes formed on one of the substrates;
   a plurality of signal electrodes (4) intersecting like a matrix with said plurality of first scanning electrodes;
   a plurality of second scanning electrodes provided along said first scanning electrodes or said signal electrodes (4);
      wherein the display apparatus further comprises the followings within each of the regions surrounded by said plurality of first scanning electrodes and said plurality of signal electrodes (4);
   a data holding circuit (5) connected to the corresponding first scanning electrodes, signal electrodes (4), and second scanning electrodes for fetching and storing a display data from the signal electrodes (4) in response to voltages applied to the first and the second scanning electrodes;
   a capacitor connected to said data holding circuit (5);
   a switching device connected to said capacitor, its switching operation being controlled by a voltage of the capacitor;
   a display electrode connected to said switching device.

4. A liquid crystal display apparatus having a pair of substrates of which at least one substrate is transparent and a liquid crystal layer sandwiched between the substrates, comprising:

   a plurality of scanning electrodes (3) formed on one of the substrates;
   a plurality of signal electrodes (4) intersecting like a matrix with each of said plurality of scanning electrodes (3);
      wherein the display apparatus further comprises the followings within each of the regions forming pixels surrounded by said plurality of scanning electrodes (3) and said plurality of signal electrodes (4);
   a sampling data holding circuit connected to the corresponding each of signal electrodes (4), for sampling and storing signal data from the signal electrode (4) in response to a scanning signal;
   a gray level selecting circuit connected to said sampling data holding circuit, for selecting the gray levels for the pixel in response to a state of the sampling of said sampling data holding circuit;
   a display electrode (750) connected to said gray level selecting circuit.

5. A liquid crystal display apparatus comprising:

   a liquid crystal layer including a liquid crystal constructing a plurality of pixels;
   a pair of boards facing to each other between which said liquid crystal layer is inserted, at least one of which is transparent;

a plurality of scanning wires ($G_1$-$G_n$) for transmitting scan pulses, distributed on one of said pair of boards;

a plurality of signal wires ($D_1$-$D_n$) for transmitting image data crossing with said plurality of scanning wires ($G_1$-$G_n$) in a matrix geometry and distributed on one of said pair of boards;

an AC voltage generation means for generating an AC voltage for driving said liquid crystal; and

a timing signal generation means (500) for generating periodically timing signals in synchronization with said liquid crystal drive voltage generated by said AC voltage generation means,

wherein a plurality of display area enclosed by a plurality of scanning wires ($G_1$-$G_n$) and a plurality of signal wire ($D_1$-$D_n$) having

a display electrode (750) placed at one side of said pair of boards;

a opposed electrodes (770) placed so as to face to said display electrode (750) through said liquid crystal layer, to which said liquid crystal drive voltage is applied by said AC voltage generation means;

a switching device for driving pixels connected to said display electrode (750);

a data hold means for holding said image data supplied from said signal wire ($D_1$-$D_n$) in responsive to said scan pulse from said scanning wire ($G_1$-$G_n$) and controlling said switching operation of said switching device for driving pixels in responsive to said held image data; and

an initializing means for initializing said voltage applied between said display electrode (750) and said opposed electrode in responsive to said timing signal supplied by said timing signal generation means (500).

6. A liquid crystal display apparatus of Claim 1, 2 or 3, wherein said switching device for driving pixels is composed of a TFT device; a signal for switching operation is put into a gate terminal of said TFT device, a drain terminal of said TFT device is connected to a display electrode (750), and a source terminal is connected to a reference line (CNT) defining an average voltage of a liquid crystal drive voltage; and a timing signal (VTMG) of a timing signal generation means (500) is generated so synchronized with a time when said liquid crystal drive voltage generated by an AC voltage generation means reaches an average voltage.

7. A liquid crystal display apparatus of Claim 1, 2 or 3, wherein said switching device for driving pixels is composed of a TFT device; a signal for switching operation is put into a gate terminal of said TFT device, a drain terminal of said TFT device is connected to a display electrode (750), and a source terminal is connected to a reference line defining an average voltage of a liquid crystal drive voltage; a timing signal (VTMG) of a timing signal generation means (500) is generated so synchronized with a time when said liquid crystal drive voltage generated by an AC voltage generation means reaches an average voltage; and a generation of said timing signal (VTMG) is interrupted at a time when said voltage applied between a display electrode and a opposed electrode reaches zero.

EP 0 797 182 A1

# FIG.1

SIGNAL DATA WRITING CIRCUIT

SCANNING WIRE SELECTING CIRCUIT

OPPOSED ELECTRODE DRIVING CIRCUIT

COMMON ELECTRODE DRIVING CIRCUIT

23

# FIG.2

# FIG.3

# FIG.4

# FIG.5

## FIG.6

11

8

17

## FIG.7

55
50
4  17  52  51  11  8        56  7        12
54
A    3    10    B    6    C    D  15  E
53

# FIG.8

# FIG.9

## FIG.10

## FIG.11

# FIG.12

# FIG.13

## FIG.14

LINE DRIVER

LINE DRIVER

Gst

Gcnd

▨ OPERATING REGION

☐ MON - OPERATING REGION

## FIG.15

Dn

32  34  35  ○ Vcnt

Gm

3

7

9

Vcom

31  36  8

# FIG.16

## FIG.17

# FIG.18

# FIG.19

# FIG.20

30

# FIG.21

# FIG.22

DATA HOLDING CIRCUIT 120

PIXEL CONTROL CIRCUIT 130

# FIG.23

# FIG.24

# FIG.25

EP 0 797 182 A1

## FIG.26

## FIG.28

# FIG.27

## FIG.29

(a) VS

(b) A

(c) B

(d) C

(e) D

(f) E

(g) F

(h) G

(i) VTMG

(j) VCP

VP  VCNT

VN

## FIG.30

## FIG.31

# FIG.32

## FIG.33

D1  D2  Dn

SW1  SW2  SWn

848

Db1  Db2  Dbn  820

**MOTION-PICTURE LATCH CIRCUIT**

846

DL1  DL2  DLn

ab1  ab2  abn  822

**MOTION-PICTURE SHIFT REGISTER CIRCUIT**

DR1  DO2

D  D  D

DR2  DOn  DRn

XClk  ab1  ab2  abn

**PANEL DISPLAY CONTROL CIRCUIT**

842  844

# FIG.34

STATIC PICTURE
ELECTRODE LINE

848

D1  D2  Dn

P1  N1  P2  Pn  Nn
N2

Db1  Db2  Dbn

820

MOTION PICTURE
LATCH CIRCUIT

C1  C2  Cm

PANEL DISPLAY CONTROL CIRCUIT

812

## FIG.35

## FIG.36

# FIG.37

PIXEL SELECTING OPERATION
DURING STATIC PICTURE DISPLAY

Xi

"L"  "H"

Yi

Di

Vmen

Vdisp        Vcom

Vcnt

Vlcd

LIGHT - OFF        LIGHT - ON        LIGHT - OFF

EP 0 797 182 A1

## FIG.38

PIXEL SELECTING OPERATION
DURING MOTION PICTURE DISPLAY

Xi  "L" "H" "-H"

Yi

Di  "sign"

Vmen  "H" "L"

Vdisp  Vcom  "sign"

Vcnt

Vlcd  "Vcnt - sign"

MOTION - PICTURE
LIGHT - OFF

MOTION - PICTURE
LIGHT - ON

EP 0 797 182 A1

# FIG.39

Xn1 ········ Xnn

Ym1

Ymm

~ 812

MOTION · PICTURE
DISPLAY REGION

STATIC PICTURE
DISPLAY REGION

# FIG.40

# FIG.41

# FIG.42

FLICKER PREVENTING
ELECTRODE DRIVING CIRCUIT

OPPOSED
ELECTRODE
DRIVING
CIRCUIT

$C_T$   $R_T$

$C_T$   $R_T$

$V_L$   $V_H$

CLK

Q

MONO - STABLE
CIRCUIT   918

Q

MONO - STABLE
CIRCUIT   919

SWITCH | 920

916
Von

917
Voff

Vdrive

# FIG.43

CLK

$\tau$

Von

Voff

VH

Vdrive   VL

## FIG.44A

## FIG.44B

## FIG.45

## FIG.46

## FIG.47

## FIG.48

## FIG.49

## FIG.50

Vdrive

Von

Vmemory

Vlc

# FIG.51A

s

g

d

n - CHANNEL TFT

# FIG.51B

s

g

d

p - CHANNEL TFT

# FIG.51C

n - CHANNEL TFT

p - CHANNEL TFT

Rds

Vgd

**European Patent Office**

## EUROPEAN SEARCH REPORT

Application Number

EP 97 10 4580

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>Y | EP 0 414 478 A (SHARP KK) 27 February 1991<br>* column 3, line 8 - column 4, line 4; figures 5,7 * | 1,2<br>3-5 | G09G3/36 |
| Y<br>A | EP 0 586 155 A (SHARP KK) 9 March 1994<br>* column 16, line 7 - column 17, line 33; figures 10,13,14 *<br>* column 19, line 52 - column 21, line 4 * | 3,5<br>1 | |
| Y | PATENT ABSTRACTS OF JAPAN<br>vol. 096, no. 002, 29 February 1996<br>& JP 07 261155 A  (SONY CORP), 13 October 1995,<br>* abstract * | 4 | |
| | | | **TECHNICAL FIELDS SEARCHED     (Int.Cl.6)**<br><br>G09G |

The present search report has been drawn up for all claims

| Place of search | Date of completion of the search | Examiner |
|---|---|---|
| THE HAGUE | 20 June 1997 | Amian, D |

EPO FORM 1503 03.82 (P04C01)